(19) Europäisches Patentamt
European Patent Office
Office européen des brevets

(11) EP 3 017 488 B1

(12) **EUROPÄISCHE PATENTSCHRIFT**

(45) Veröffentlichungstag und Bekanntmachung des Hinweises auf die Patenterteilung:
**19.08.2020 Patentblatt 2020/34**

(21) Anmeldenummer: **14732241.6**

(22) Anmeldetag: **25.06.2014**

(51) Int Cl.:
***H01L 51/54*** *(2006.01)*

(86) Internationale Anmeldenummer:
**PCT/EP2014/063410**

(87) Internationale Veröffentlichungsnummer:
**WO 2015/000763 (08.01.2015 Gazette 2015/01)**

(54) **OPTOELEKTRONISCHES BAUELEMENT UND VERFAHREN ZUR HERSTELLUNG EINES OPTOELEKTRONISCHEN BAUELEMENTS**

OPTOELECTRONIC DEVICE AND METHOD FOR PRODUCING AN OPTOELECTRONIC DEVICE

COMPOSANT OPTO-ÉLECTRONIQUE ET PROCÉDÉ DE FABRICATION D'UN COMPOSANT OPTO-ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.07.2013 DE 102013106949**

(43) Veröffentlichungstag der Anmeldung:
**11.05.2016 Patentblatt 2016/19**

(73) Patentinhaber: **OSRAM OLED GmbH**
**93049 Regensburg (DE)**

(72) Erfinder:
- **JAEGER, Arndt**
  **93051 Regensburg (DE)**
- **SCHMID, Günter**
  **91334 Hemhofen (DE)**

(74) Vertreter: **Epping - Hermann - Fischer Patentanwaltsgesellschaft mbH**
**Schloßschmidstraße 5**
**80639 München (DE)**

(56) Entgegenhaltungen:
**EP-A1- 2 543 671**
**EP-A2- 1 318 553**
**US-A1- 2011 089 408**
**US-A1- 2011 215 304**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 017 488 B1

## Beschreibung

Die vorliegende Erfindung betrifft ein optoelektronisches Bauelement und ein Verfahren zur Herstellung eines optoelektronischen Bauelements.

Strahlung emittierende Bauelemente, wie beispielsweise organische Leuchtdioden (OLED), haben häufig das Problem, eine oder mehrere Schichten mit einer hohen Leitfähigkeit von Elektronen und/oder Löchern bereitzustellen. Eine höhere Leitfähigkeit in den Schichten, beispielsweise in Lochbeziehungsweise Elektronen-Transport-Schichten, beeinflusst oft positiv die Exzitonendichte in einer Strahlung emittierenden Schicht. Bei einer unzureichenden Leitfähigkeit in den Schichten können hingegen verstärkte Effizienz- und Leuchtdichteverluste in Strahlung emittierenden Bauelementen die Folge sein.

Eine zu lösende Aufgabe besteht darin, ein optoelektronisches Bauelement sowie ein Verfahren zur Herstellung eines optoelektronischen Bauelements anzugeben, die eine verbesserte Leitfähigkeit aufweisen.

Diese Aufgabe wird durch die Gegenstände mit den Merkmalen der unabhängigen Patentansprüche gelöst. Vorteilhafte Ausführungsformen und Weiterbildungen der Gegenstände sind in den abhängigen Ansprüchen angegeben und gehen aus der nachfolgenden Beschreibung und den Zeichnungen hervor.

Ein optoelektronisches Bauelement gemäß einer Ausführungsform umfasst ein Substrat, eine erste Elektrode, eine zweite Elektrode, zumindest eine organische funktionelle Schicht, die zwischen erster Elektrode und zweiter Elektrode angeordnet ist. Die organische funktionelle Schicht umfasst ein Matrixmaterial, eine erste Verbindung und eine zweite Verbindung, wobei die erste Verbindung mit der zweiten Verbindung und die erste Verbindung und/oder die zweite Verbindung mit dem Matrixmaterial wechselwirken. Durch die Wechselwirkungen wird eine Leitfähigkeit der organischen funktionellen Schicht erzeugt, die gegenüber der Leitfähigkeit des reinen Matrixmaterials verbessert ist.

Die Erfinder haben überraschenderweise festgestellt, dass im Betrieb eines optoelektronischen Bauelements eine Kombination aus Matrixmaterial, erster Verbindung und zweiter Verbindung in zumindest einer organischen funktionellen Schicht eine erhöhte Leitfähigkeit der organischen funktionellen Schicht bewirkt. Dies resultiert weiterhin in einer erhöhten Leuchtdichte und Rekombinationseffizienz und führt damit zu einer erhöhten Lichtausbeute des optoelektronischen Bauelements. Die durch Ladungsträgerrekombination erzeugte elektromagnetische Strahlung kann grundsätzlich durch die erste beziehungsweise zweite Elektrode oder durch beide ausgekoppelt werden.

Elektromagnetische Strahlung umfasst hier und im Folgenden bevorzugt elektromagnetische Strahlung mit einer oder mehreren Wellenlängen oder Wellenlängenbereichen aus einem ultravioletten bis infraroten Spektralbereich, besonders bevorzugt ist die elektromagnetische Strahlung sichtbares Licht mit Wellenlängen oder Wellenlängenbereichen aus einem sichtbaren Spektralbereich zwischen etwa 350 nm und etwa 800 nm.

Im Rahmen dieser Anmeldung werden unter dem Begriff "Bauelement" nicht nur fertige Bauelemente wie beispielsweise organische Leuchtdioden (OLEDs) verstanden, sondern auch Substrate und/oder organische Schichtenfolgen. Ein Verbund einer organischen Schichtenfolge mit einer ersten Elektrode und einer zweiten Elektrode kann beispielsweise bereits ein Bauelement darstellen und ein Bestandteil eines übergeordneten zweiten Bauelements bilden, in dem beispielsweise zusätzlich elektrische Anschlüsse vorhanden sind.

"Zwischen erster Elektrode und zweiter Elektrode angeordnet" schließt nicht aus, dass weitere Schichten oder Elemente zwischen den Elektroden angeordnet sind, wobei die funktionelle organische Schicht jedoch stets zumindest in mittelbaren elektrischen und/oder mechanischen Kontakt zu einer der Elektroden steht.

Unter "Leitfähigkeit" ist hier und im Folgenden die Fähigkeit mindestens eines Stoffes zu verstehen, Ladungsträger, beispielsweise negative Ladungsträger (Elektronen) und/oder positive Ladungsträger (Löcher) zu transportieren. Die Leitfähigkeit kann durch Wechselwirkung von mindestens zwei oder drei Stoffen erzeugt werden, beispielsweise durch Wechselwirkung der ersten Verbindung mit der zweiten Verbindung oder der ersten Verbindung und/oder der zweiten Verbindung mit dem Matrixmaterial. Die Leitfähigkeit hängt von dem Produkt aus Ladung, Ladungsträgerkonzentration und Beweglichkeit der Ladungsträger ab.

Bei der hier beschriebenen organischen funktionellen Schicht ist die Leitfähigkeit größer als eine Summe aus einer ersten Leitfähigkeit, welche durch alleinige Wechselwirkung der ersten Verbindung mit dem Matrixmaterial erzeugt wird, und einer zweiten Leitfähigkeit, welche durch alleinige Wechselwirkung der zweiten Verbindung mit dem Matrixmaterial erzeugt wird. Durch das Zusammenwirken von erster und zweiter Verbindung werden in der organischen funktionellen Schicht ein erhöhter Teilchentransport, beispielsweise Löcher, und im optoelektronischen Bauelement eine erhöhte Leuchtdichte und Effizienz erzeugt.

Unter "alleinige Wechselwirkung" versteht man in diesem Zusammenhang, dass erste Verbindung und Matrixmaterial oder zweite Verbindung und Matrixmaterial ausschließlich untereinander wechselwirken. Insbesondere kann "alleinige Wechselwirkung" bedeuten, dass lediglich erste Verbindung und Matrixmaterial oder zweite Verbindung und Matrixmaterial leitfähig sind.

Unter der Wechselwirkung der ersten Verbindung mit der zweiten Verbindung und/oder der ersten Verbindung und/oder der zweiten Verbindung mit dem Matrixmaterial wird in diesem Zusammenhang verstanden, dass sich zwischen der ersten Verbindung und der zweiten Verbindung beziehungsweise zwischen der ersten Verbindung und/oder zweiten

Verbindung und dem Matrixmaterial zwischenmolekulare Kräfte, intermolekulare Kräfte, innermolekulare Kräfte und/oder chemische Bindungen, beispielsweise ionische Wechselwirkung, Wasserstoffbrücken, Dipolwechselwirkung, Van-der-Waals-Wechselwirkung, ionische Bindung, kovalente Bindung, koordinativen Bindung und/oder metallische Bindung, ausbilden.

Insbesondere bildet die erste Verbindung mit der zweiten Verbindung und die erste Verbindung mit dem Matrixmaterial zumindest eine koordinative Bindung aus und/oder die erste Verbindung mit der zweiten Verbindung und die zweite Verbindung mit dem Matrixmaterial zumindest eine koordinative Bindung aus.

"Koordinative Bindung" bezeichnet hier und im Folgenden, dass zwischen einem Elektronendonator und einem Elektronenakzeptor eine Bindung ausgebildet wird, wobei der Elektronendonator alle zur Ausbildung der koordinativen Bindung benötigten Elektronen zur Verfügung stellt, und wobei der Elektronenakzeptor die zur Verfügung gestellten Elektronen aufnimmt. Insbesondere kann der Elektronendonator beziehungsweise der Elektronenakzeptor Elektronen nur teilweise beziehungsweise geringfügig austauschen.

Gemäß einer Ausführungsform ist die erste Verbindung ein Elektronakzeptor in Bezug auf das Matrixmaterial und/oder ein Elektronakzeptor in Bezug auf die zweite Verbindung.

Gemäß einer weiteren Ausführungsform ist die zweite Verbindung ein Elektronenakzeptor in Bezug auf das Matrixmaterial und/oder ein Elektronendonator in Bezug auf die erste Verbindung.

Gemäß einer anderen Ausführungsform ist die zweite Verbindung im Vergleich zur ersten Verbindung gegenüber dem Matrixmaterial stärker elektronenakzeptierend.

Gemäß einer Ausführungsform können neben erster und zweiter Verbindung auch noch zusätzliche Verbindungen, beispielsweise ein bis drei zusätzliche Verbindungen, in das Matrixmaterial eingebettet sein, welche dazu befähigt sind, mit der ersten Verbindung, zweiten Verbindung, dem Matrixmaterial und/oder untereinander zu wechselwirken, beispielsweise durch Ausbildung von koordinativen Bindungen. Das Matrixmaterial kann alternativ oder zusätzlich eine Mischung aus mehreren verschiedenen Matrixmaterialien sein.

Gemäß einer Ausführungsform ist das optoelektronische Bauelement ein organisches elektronisches Bauelement und z.B. in Form einer organischen Leuchtdiode (OLED) ausgeformt. Dabei kann die OLED beispielsweise eine erste Elektrode auf dem Substrat aufweisen. Über der ersten Elektrode kann zumindest die organische funktionelle Schicht oder eine Mehrzahl von funktionellen Schichten aus organischen Materialien aufgebracht sein. Über der organischen funktionellen Schicht oder der Mehrzahl der funktionellen Schichten ist eine zweite Elektrode aufgebracht.

Dabei kann die organische funktionelle Schicht aus einer Gruppe ausgewählt sein, die eine Strahlung emittierende Schicht, eine Lochtransportschicht, eine Lochinjektionsschicht und eine Lochblockierungsschicht umfasst. Insbesondere handelt es sich bei der organischen funktionellen Schicht um eine Lochtransportschicht und/oder Lochinjektionsschicht.

Jede weitere organische funktionelle Schicht kann aus einer Gruppe ausgewählt werden, die eine Elektroneninjektionsschicht, eine Elektronentransportschicht, eine Lochblockierungsschicht oder eine Strahlung emittierende Schicht umfasst. Die Strahlung emittierende Schicht kann eine einzelne Schicht oder mehrere Teilschichten umfassen, beispielsweise Schichten oder Teilschichten, welche im grünen, roten und/oder blauen Spektralbereich der elektromagnetischen Strahlung emittieren. Alternativ oder zusätzlich ist es möglich, dass die Elektroneninjektionsschicht, Elektronentransportschicht und Lochblockierungsschicht eine einzelne Schicht oder mehrere Teilschichten aufweisen.

Die Strahlung emittierende Schicht kann dazu einen aktiven Bereich aufweisen, der geeignet ist, im Betrieb des organischen elektronischen Bauelements elektromagnetische Strahlung abzustrahlen.

Gemäß einer Ausführungsform kann das optoelektronische Bauelement zusätzlich eine Verkapselung aufweisen.

Alternativ ist gemäß einer weiteren Ausführungsformen das optoelektronische Bauelement in Form eines Transistors, beispielsweise eines Feldeffekttransistors, einer Solarzelle oder eines Fotodetektors ausgeformt.

Das Substrat kann Glas, Quarz, Kunststofffolien, Metall, Metallfolien, Siliziumwafer oder ein anderes geeignetes Substratmaterial umfassen. Die OLED kann auch als sogenannter "Bottom-Emitter" ausgeführt sein, das heißt, dass die im aktiven Bereich erzeugte elektromagnetische Strahlung durch das Substrat abgestrahlt wird. Das Substrat weist dann eine Transparenz für zumindest einen Teil der elektromagnetischen Strahlung auf. Vorteilhafterweise kann die erste Elektrode, die als Anode ausgeführt sein kann, transparent sein und/oder ein Löcher injizierendes Material umfassen. Die erste Elektrode kann beispielsweise ein transparentes leitendes Oxid aufweisen oder daraus bestehen. Transparente leitende Oxide (transparent conductive oxides, kurz "TCO") sind in der Regel Metalloxide, wie beispielsweise Zinkoxid, Zinnoxid, Kadmiumoxid, Titanoxid, Indiumoxid oder Indiumzinnoxid (ITO). Neben binären Metallsauerstoffverbindungen, wie beispielsweise ZnO, $SnO_2$ oder $In_2O_3$ gehören auch ternäre Metallsauerstoffverbindungen, wie beispielsweise $Zn_2SnO_4$, $CdSnO_3$, $ZnSnO_3$, $MgIn_2O_4$, $GaInO_3$, $Zn_2In_2O_5$ oder $In_4Sn_3O_{12}$ oder Mischungen unterschiedlicher transparenter leitender Oxide zu der Gruppe der TCOs. Dabei entsprechen die TCOs nicht zwingend einer stöchiometrischen Zusammensetzung und können weiterhin p- oder n-dotiert sein.

Die zumindest eine organische funktionelle Schicht kann organische Polymere, organische Oligomere, organische Monomere, organische kleine nichtpolymere Moleküle ("small molecules") oder Kombinationen daraus aufweisen.

Die zweite Elektrode kann als Kathode ausgeführt sein und somit als Elektronen injizierendes Material dienen. Als Kathodenmaterial können sich unter anderem insbesondere Aluminium, Barium, Indium, Silber, Gold, Magnesium, Kalzium oder Lithium sowie Verbindungen, Kombinationen und Legierungen davon als vorteilhaft erweisen. Alternativ oder zusätzlich kann die zweite Elektrode auch eines der oben genannten TCOs aufweisen. Zusätzlich oder alternativ kann die zweite Elektrode auch transparent ausgeführt sein und/oder die erste Elektrode kann als Kathode und die zweite Elektrode als Anode ausgeführt sein. Das bedeutet insbesondere, dass die OLED auch als "Top-Emitter" ausgeführt sein kann.

Die erste und/oder die zweite Elektrode können jeweils großflächig ausgebildet sein. Dadurch kann im Falle einer OLED eine großflächige Abstrahlung der im aktiven Bereich erzeugten elektromagnetischen Strahlung ermöglicht werden.

"Großflächig" kann dabei bedeuten, dass das organische elektronische Bauelement eine Fläche von größer oder gleich einigen $mm^2$, bevorzugt größer oder gleich ein $cm^2$ und besonders bevorzugt größer oder gleich ein $dm^2$ aufweist. Alternativ oder zusätzlich können die erste und/oder die zweite Elektrode zumindest in Teilbereichen strukturiert ausgebildet sein. Dadurch kann eine strukturierte Abstrahlung der im aktiven Bereich erzeugten elektromagnetischen Strahlung ermöglicht werden, etwa in Form von Pixeln oder Piktogrammen.

Bei der Herstellung der funktionellen Schicht wird durch gleichzeitiges Verdampfen der ersten Verbindung, der zweiten Verbindung und des Matrixmaterials aus unterschiedlichen Quellen eine dritte Verbindung durch Komplexbildung von erster und zweiter Verbindung in der Gasphase oder in der Schicht erzeugt. Insbesondere sind die erste und zweite Verbindung in dem Matrixmaterial homogen verteilt. Alternativ kann ein Konzentrationsgradient aus erster und zweiter Verbindung in dem Matrixmaterial eingestellt werden. Die dritte Verbindung bildet insbesondere einen Elektronendonator-Elektronenakzeptor-Komplex. Zusätzlich wird durch die dritte Verbindung eine höhere Leitfähigkeit der organischen funktionellen Schicht erzeugt.

Gemäß einer Ausführungsform ist die erste Verbindung und/oder die zweite Verbindung in dem Matrixmaterial im Überschuss vorhanden. Dadurch kann die Leitfähigkeit der organischen funktionellen Schicht, beispielsweise durch die Konzentration von Löchern auch prozesstechnisch gesteuert werden.

Gemäß einer weiteren Ausführungsform ist das Matrixmaterial im Überschuss im Vergleich zu der ersten und/oder zweiten Verbindung vorhanden, beispielsweise bevorzugt im Überschuss von mehr als 75%, insbesondere bevorzugt im Überschuss über 90%. Die Leitfähigkeit ist proportional zur Mobilität der Ladungsträger und der Zahl der Ladungsträger. Normalerweise sinkt die Mobilität bei Zugabe einer ersten Verbindung und/oder zweiten Verbindung zu dem Matrixmaterial. Dies wird aber überkompensiert durch die Generierung von Ladungsträgern, sodass schlussendlich die Leitfähigkeit um mehrere Größenordungen steigt. Über das Verhältnis Matrixmaterial zu erste Verbindung und/oder zweite Verbindung kann daher die Leitfähigkeit gesteuert werden. Gradienten horizontal und vertikal sind prozesstechnisch möglich.

Die Wechselwirkung der ersten Verbindung mit der zweiten Verbindung führt zu einer Koordination der beiden Verbindungen untereinander. Die organische funktionelle Schicht umfasst daher eine dritte Verbindung im koordinierten Zustand, das heißt unter Ausbildung zumindest einer koordinativen Bindung aus erster und zweiter Verbindung. In der organischen funktionellen Schicht liegt eine Nahordnung vor. Unter Nahordnung ist zu verstehen, dass nicht die gesamte Schicht an sich kristallin ist, aber um die erste Verbindung in seinem direkten Umfeld die zweite Verbindung nach einem bestimmten Muster angeordnet ist. Die gesamte organische funktionelle Schicht ist somit an sich amorph und weist somit keine Fernordnung auf.

Gemäß einer Ausführungsform umfasst die erste Verbindung einen Metallkomplex mit mindestens einem Metallzentralatom. Das Metallzentralatom der ersten Verbindung kann aus einem Element des Periodensystems ausgewählt sein, beispielsweise aus einem Element der I. Nebengruppe, VI. Nebengruppe und V. Hauptgruppe des Periodensystems. Insbesondere ist das Metallzentralatom aus einer Gruppe ausgewählt, die Cu, Cr, Mo und Bi umfasst.

Alternativ oder zusätzlich können zumindest zwei Metallzentralatome direkt über eine Metall-Metall-Bindung und/oder indirekt miteinander verknüpft sein. "Indirekt" bedeutet in diesem Zusammenhang, dass zwei Metall-Atome mit zumindest einem Halbmetall-Atom und/oder Nichtmetall-Atom, beispielsweise O, N, P, C, Si oder B, verknüpft bzw. überbrückt sind, wobei keine direkte Metall-Metall-Bindung ausgebildet wird.

Gemäß zumindest einer Ausführungsform ist die erste Verbindung ein Kupferkomplex. In dem Kupferkomplex kann zumindest ein Kupferkation in der Oxidationsstufe II enthalten sein.

Gemäß zumindest einer Ausführungsform weist der Kupferkomplex zumindest einen Liganden auf, der eine Aryloxygruppe und eine Iminiumgruppe enthält.

Gemäß zumindest einer Ausführungsform ist die Aryloxygruppe und die Iminiumgruppe des Liganden eine Salicylaldiminatgruppe. Unter Salicylaldiminatgruppe ist ein Ligand zu verstehen, der aus einem Salicylaldehyd und einem aromatischen Mono- oder Diamin oder einem olefinischen Mono-oder Diamin gebildet ist. Somit umfasst der Ligand eine aminkondensierte Salicylaldehydgruppe und ist zur Komplexierung zwischen Aryloxygruppe und dem Stickstoff der Iminiumgruppe, beispielsweise einer Azomethingruppe, befähigt.

Gemäß zumindest einer Ausführungsform weist der Kupferkomplex eine der allgemeinen Formeln I oder II auf:

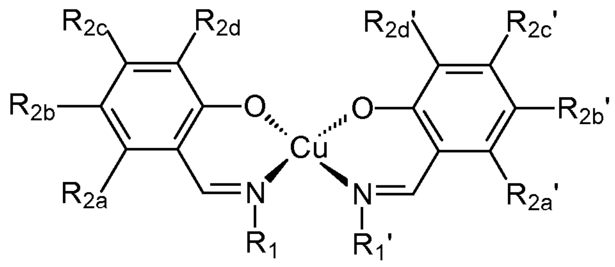

(I)

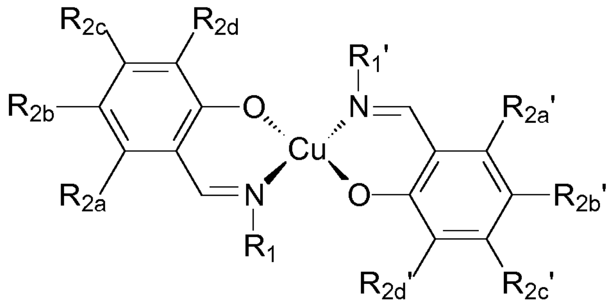

(II)

Formel (I) stellt ein cis-Isomer des Kupferkomplexes dar, Formel (II) ein trans-Isomer. Ein solcher Kupferkomplex enthält somit zwei Liganden, die an das Kupferkation koordiniert bzw. gebunden sind.

In den Formeln (I) und (II) gilt: $R_1$, $R_{1'}$, $R_{2x}$ und $R_{2x'}$ (wobei x jeweils für a, b, c oder d steht) sind unabhängig voneinander ausgewählt aus einer Gruppe, die unverzweigte, verzweigte, kondensierte, ringförmige, unsubstituierte und substituierte Alkylreste, substituierte und unsubstituierte Aromaten, substituierte und unsubstituierte Heteroaromaten umfasst.

Beispiele für solche Substituenten sind Methylgruppen, Ethylgruppen, Decahydronaphthylgruppen, Cyclohexylgruppen und Alkylreste, die vollständig oder teilweise substituiert sein können und bis zu 20 Kohlenstoffatome aufweisen können. Diese Alkylreste können weiterhin Ethergruppen, wie Ethoxy- oder Methoxygruppen, Estergruppen, Amidgruppen, Carbonatgruppen oder auch Halogene, insbesondere F, enthalten.

Beispiele für substituierte oder unsubstituierte Aromaten sind Phenyl, Diphenyl, Naphthyl, Phenanthryl oder Benzyl.

Gemäß zumindest einer Ausführungsform sind $R_1$ und $R_{1'}$, $R_{2x}$ und $R_{2x'}$ jeweils gleich.

Gemäß zumindest einer Ausführungsform sind $R_1$ und $R_{1'}$ miteinander verbunden.

Gemäß zumindest einer Ausführungsform weist zumindest einer aus $R_1$, $R_{1'}$, $R_{2x}$ und $R_{2x'}$ einen elektronenziehenden Substituenten auf.

Gemäß einer Ausführungsform umfasst die erste Verbindung zumindest einen Liganden. Die Liganden sind vorzugsweise an zumindest ein Metallzentralatom der ersten Verbindung koordiniert und/oder gebunden. Liganden können aus einer Gruppe ausgewählt werden, die in der WO 2011/033023 A1 beziehungsweise US 2011/0089408 A1 oder DE 102010013495 A1 beziehungsweise WO 2011/120709 A1 publiziert sind. Als Ligand eignet sich beispielsweise Pentafluorbenzoat, fluoriertes Acetat oder fluoriertes Acetylacetonat. Eine erste Verbindung kann beispielsweise fluoriertes Kupfer(I)acetat, fluoriertes Kupferacetylacetonat oder Kupfer (II) trifluormethansulfonat sein.

Insbesondere kann der Ligand der ersten Verbindung aus folgender Gruppe und Kombinationen daraus ausgewählt sein:

Fluorierte oder nicht-fluorierte Benzoesäuren wie z.B. 2-(Trifluoromethyl)benzoesäure; 3,5-Difluorobenzoesäure; 3-Hydroxy-2,4,6-triiodobenzoesäure; 3-Fluoro-4-methylbenzoesäure; 3-(Trifluoromethoxy)benzoesäure; 4-(Trifluoromethoxy)benzoesäure; 4-Chloro-2,5-difluorobenzoesäure; 2-Chloro-4,5-difluorobenzoesäure; 2,4,5-Trifluorobenzoesäure; 2-Fluorobenzoesäure; 4-Fluorobenzoesäure; 2,3,4-Trifluorobenzoesäure; 2,3,5-Trifluorobenzoesäure; 2,3-Difluorobenzoesäure; 2,4-Bis(trifluoromethyl)benzoesäure; 2,4-Difluorobenzoesäure; 2,5-Difluorobenzoesäure; 2,6-Bis(trifluoromethyl)benzoesäure; 2,6-Difluorobenzoesäure; 2-Chloro-6-fluorobenzoesäure; 2-Fluoro-4-(trifluoromethyl)benzoesäure; 2-Fluoro-5-(trifluoromethyl)benzoesäure; 2-Fluoro-6-(trifluoromethyl)benzoesäure; 3,4,5-Trifluorobenzoesäure; 3,4-Difluorobenzoesäure; 3,5-Bis(trifluoromethyl)benzoesäure; 3-(Trifluoromethyl)benzoesäure; 3-Chloro-4-fluorobenzoesäure; 3-Fluoro-5-(trifluoromethyl)benzoesäure; 3-Fluorobenzoesäure; 4-Fluoro-2-(trifluoromethyl)benzoesäure; 4-Fluoro-3-(trifluoromethyl)benzoesäure; 5-Fluoro-2-methylbenzoesäure; 2-(Trifluoromethoxy)benzoesäure; 2,3,5-Trichlorobenzoesäure; 4-(Trifluoromethyl)benzoesäure; Pentafluorobenzoesäure; 2,3,4,5-Tetrafluorobenzoesäure,

fluorierte oder nicht-fluorierte Phenylessigsäure wie z.B. 2-Fluor-Phenylessigsäure; 3-Fluor-Phenylessigsäure; 4-Fluor-Phenylessigsäure; 2,3-Difluor-Phenylessigsäure; 2,4-Difluor-Phenylessigsäure; 2,6-Difluor-Phenylessigsäure; 3,4-Difluor-Phenylessigsäure; 3,5-Difluor-Phenylessigsäure; Pentafluor-Phenylessigsäure; 2-Chloro-6-fluor-Phenylessigsäure; 2-Chloro-3,6-difluor-Phenylessigsäure; 3-Chloro-2,6-difluor-Phenylessigsäure; 3-Chloro-4-fluor-Phenylessigsäure; 5-Chloro-2-fluor-Phenylessigsäure; 2,3,4-Trifluor-Phenylessigsäure; 2,3,5-Trifluor-Phenylessigsäure; 2,3,6-Trifluor-Phenylessigsäure; 2,4,5-Trifluor-Phenylessigsäure; 2,4,6-Trifluor-Phenylessigsäure; 3,4,5-Trifluor-Phenylessigsäure; 3-Chloro-2-fluor-Phenylessigsäure; $\alpha$-Fluor-Phenylessigsäure; 4-Chloro-2-fluor-Phenylessigsäure; 2-Chloro-4-fluor-Phenylessigsäure; $\alpha$,$\alpha$-Difluor-Phenylessigsäure; Ethyl 2,2-Difluor-2-phenylacetate; und

fluorierte oder nicht-fluorierte Essigsäure wie z.B. Methyltrifluoroacetat; Allyl-trifluoroacetat; Ethyltrifluoroacetat; Isopropyl-trifluoroacetat; 2,2,2-Trifluoroethyl-trifluoroacetat; Difluoroessigsäure; Trifluoroessigsäure; Methyl-chlorodifluoroacetat; Ethylbromodifluoroacetat; Chlorodifluoroessigsäure; Ethylchlorofluoroacetat; Ethyl-difluoroacetat; (3-Chlorophenyl)-difluoroessigsäure; (3,5-Difluorophenyl)-difluoroessigsäure; (4-Butylphenyl)difluoroessigsäure; (4-tert-Butylphenyl)difluoroessigsäure; (3,4-Dimethylphenyl)-difluoroessigsäure; (3-Chloro-4-fluorophenyl)-difluoroessigsäure; (4-Chlorophenyl)-difluoroessigsäure; 2-Biphenyl-3',5'-difluoroessigsäure; 3-Biphenyl-3',5'-difluoroessigsäure; 4-Biphenyl-3',5'-difluoroessigsäure; 2-Biphenyl-3',4'-difluoroessigsäure; 3-Biphenyl-3',4'-difluoroessigsäure; 4-Biphenyl-3',4'-difluoroessigsäure; 2,2-Difluoro-propionsäure bzw. deren höheren Homologen. Falls die Liganden L saure Gruppen aufweisen; können die Gruppen in einer bevorzugten Ausführungsform deprotoniert vorliegen.

In zumindest einer weiteren Ausführungsform ist der Ligand ausgewählt aus der Gruppe der nicht substituierten, partiell fluorierten oder per-fluorierten organischen Carbonsäuren. Organische Carbonsäuren können generell ausgewählt werden aus den Gruppen der aliphatisch, gesättigten Monocarbonsäuren; aliphatisch, ungesättigten Monocarbonsäuren; aliphatisch, gesättigten Dicarbonsäuren; aliphatisch, gesättigten Tricarbonsäuren; aliphatisch, ungesättigten Dicarbonsäuren; aromatischen Carbonsäuren; heterocyclischen Carbonsäuren; aliphatisch, ungesättigten, cyclischen Monocarbonsäuren. Besonders bevorzugte partielle oder perfluorierte Liganden L werden ausgewählt aus substituierten oder unsubstituierten Verbindungen der Essigsäure, Phenylessigsäure und/oder Benzoesäure und sind beispielhaft oben angeführt. Besonders bevorzugt ist nicht-fluorierte, partiell fluorierte oder perfluorierte Essigsäure.

Gemäß zumindest einer Ausführungsform ist zumindest einer der Liganden zwischen zwei Metallen verbrückend angeordnet.

In einer Ausführungsform weist eine erste Verbindung Bi als Metallzentralatom auf, das aber nicht mit einem verbrückenden Liganden koordiniert ist.

Gemäß einer Ausführungsform umfasst die erste Verbindung, beispielsweise das Metallzentralatom und/oder der Ligand der ersten Verbindung, zumindest eine Koordinationsstelle.

Gemäß einer Ausführungsform umfasst die erste Verbindung, beispielsweise das Metallzentralatom der ersten Verbindung, zumindest eine freie Koordinationsstelle, welche dazu befähigt ist, ein Elektronenpaar eines zweiten Stoffes, beispielsweise der zweiten Verbindung, aufzunehmen und eine koordinative Bindung auszubilden. Dies kann auch als Lewissäure-Lewisbase-Wechselwirkung bezeichnet werden.

"Koordinationsstelle" bezeichnet hier und im Folgenden zumindest eine Bindungsstelle. Die Koordinationsstellen der ersten Verbindung können mit der zweiten Verbindung und/oder mit dem Matrixmaterial wechselwirken. Freie Koordinationsstellen der ersten Verbindung können bedeuten, dass leere Orbitale des Metallzentralatoms oder der Metallzentralatome, beispielsweise d-Orbitale, p-Orbitale oder f-Orbitale, vorhanden sind, welche bei Wechselwirkungen mit Elektronenpaaren der zweiten Verbindung und/oder mit dem Matrixmaterial besetzt werden. Durch die Überlappung der Orbitale kann ein Elektronendonator-Elektronenakzeptor-Komplex erzeugt werden, wobei Löcher (Defektelektronen) wandern. Beim Lochtransport füllt ein Elektron aus einem HOMO (**H**ighest **O**ccupied **M**olecular **O**rbital) ein Loch auf. Der Transport der Löcher erfolgt über das Matrixmaterial, da hier Percolationspfade vorliegen. Der Elektronenakzeptor zieht ein Elektron ganz oder teilweise aus dem Matrixmaterial und erzeugt damit ein Loch im Matrixmaterial. Dieses Loch wandert dann nach obigem Prozess. Damit wird die Lochleitfähigkeit, die Effizienz und Lebensdauer des optoelektronischen Bauelements erhöht.

Zusätzlich oder alternativ können die Koordinationsstellen leicht zugänglich sein und sind nicht durch Liganden abgeschirmt.

Gemäß einer Ausführungsform umfasst die erste Verbindung eine Struktureinheit 1

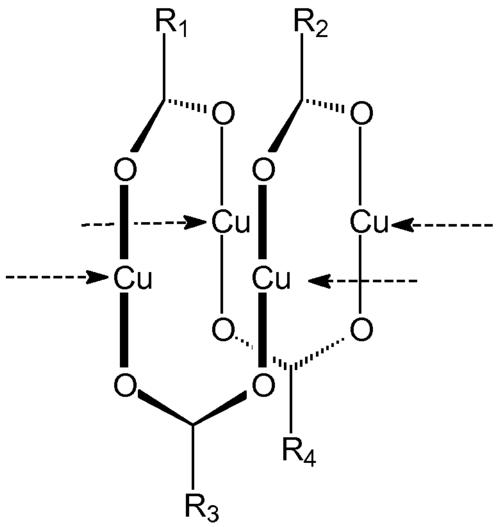

und/oder eine Struktureinheit 2

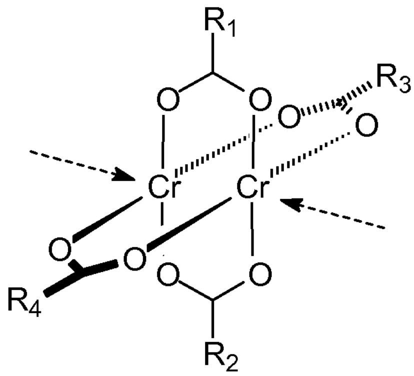

wobei Cu der Struktureinheit 1 nicht zwangsläufig nur Kupfer bedeutet, sondern Cu für ein komplexiertes Metall steht, welches aus einer Gruppe, die Kupfer, Chrom, Molybdän und Bismut und Kombinationen daraus umfasst, ausgewählt ist, wobei Cr der Struktureinheit 2 nicht zwangsläufig nur Chrom bedeutet, sondern Cr für ein komplexiertes Metall steht, welches aus einer Gruppe, die Kupfer, Chrom, Molybdän und Bismut und Kombinationen daraus umfasst, ausgewählt ist. Insbesondere steht Cr für ein zweiwertiges Bismut. $R_1$, $R_2$, $R_3$ und/oder $R_4$ sind gleich oder ungleich und jeweils aus einer Gruppe ausgewählt, die substituierte oder unsubstituierte Kohlenwasserstoffreste, Alkyl-Reste, Cyclo-Alkylreste, Heterocyclo-Alkyl-Reste, Aryl-Reste, Heteroaryl-Reste und Kombinationen daraus umfassen. Die Kohlenwasserstoffreste oder Alkyl-Reste können verzweigt, linear oder cyclisch sein. Die Aryl- und/oder Heteroaryl-Reste können einen Ring oder eine Mehrzahl von Ringen aufweisen. Die Ringe können kondensiert sein. Unter "Ring" ist in diesem Zusammenhang ein cyclischer Zusammenschluss von Atomen zu verstehen, die beispielsweise aus einer Gruppe ausgewählt sind, die C, S, N, Si, O, P und Kombinationen daraus umfasst. "Kondensierte" Ringe bedeutet im diesem Zusammenhang, dass eine Mehrzahl von Ringen zumindest ein gemeinsames Atom aufweisen. So kann bereits eine Spiroverbindung, deren Ringe nur an einem Atom verbunden sind, als kondensiert bezeichnet werden. Insbesondere teilen sich zumindest zwei Ringe miteinander zwei Atome.

Gemäß zumindest einer Ausführungsform bilden Metallzentralatome, die Cr und/oder Mo umfassen, eine dimere erste Verbindung. Cu als Metallzentralatom bildet eine tetramere, hexamere, etc. erste Verbindung. Insbesondere bildet dreiwertiges Bi als Metallzentralatom keine erste Verbindung nach Struktureinheit 2.

Insbesondere sind 2 bis 6 Ringe, insbesondere 4 Ringe, kondensiert. Alternativ oder zusätzlich kann der Ring oder die Mehrzahl der Ringe eine Konjugation aufweisen. "Konjugation" bedeutet in diesem Zusammenhang, dass der Ring oder die Mehrzahl der Ringe alternierend Einfach- und Doppelbindungen aufweisen.

Die Pfeile in den Struktureinheiten 1 oder 2 zeigen mögliche Koordinationsstellen an den Metallzentralatomen der ersten Verbindung.

Die Struktureinheit 1 weist mindestens vier freie Koordinationsstellen auf. Die Struktureinheit 2 weist mindestens zwei Koordinationsstellen auf.

Verzweigte, lineare oder cyclische Kohlenwasserstoffreste können insbesondere 1-20 Kohlenstoffatome, beispielsweise Methyl-, Ethyl- oder kondensierte Ringe, wie Decahydronaphthyl oder Adamantyl, Cyclohexyl oder ganz oder teilweise substituierte Alkyl-Reste umfassen. Alternativ oder zusätzlich können $R_1$, $R_2$, $R_3$ und/oder $R_4$ substituierte oder unsubstituierte Aryl-Reste, zum Beispiel Phenyl, Biphenyl, Naphthyl, Phenanthryl, Benzyl, Mesityl oder Heteroaryl Reste, zum Beispiel substituierte oder unsubstituierte Reste ausgewählt aus folgendem aromatischen Grundstrukturen (Schema 1), umfassen:

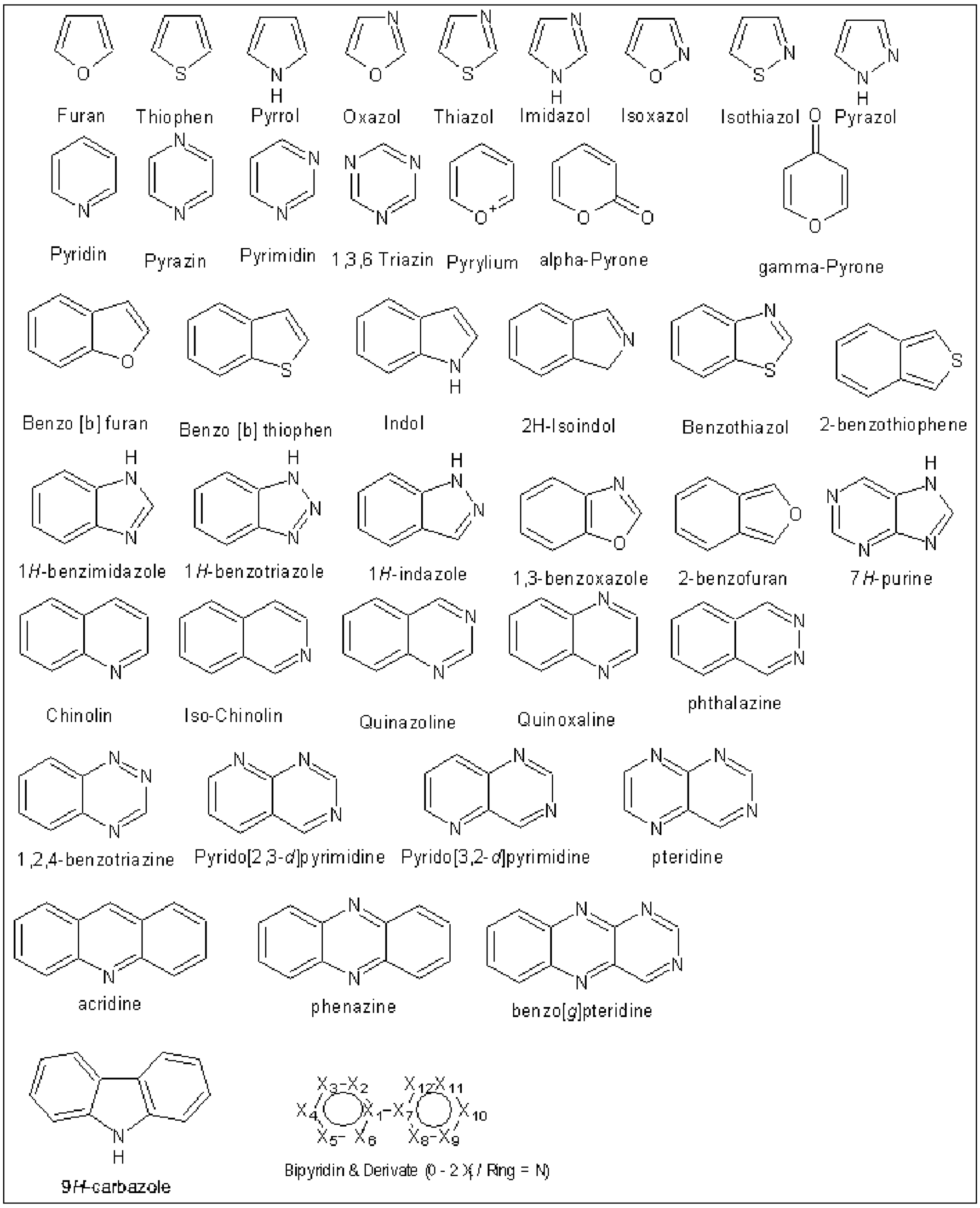

Furan, Thiophen, Pyrrol, Oxazol, Thiazol, Imidazol, Isoxazol, Isothiazol, Pyrazol

Pyridin, Pyrazin, Pyrimidin, 1,3,6 Triazin, Pyrylium, alpha-Pyrone, gamma-Pyrone

Benzo [b] furan, Benzo [b] thiophen, Indol, 2H-Isoindol, Benzothiazol, 2-benzothiophene

1*H*-benzimidazole, 1*H*-benzotriazole, 1*H*-indazole, 1,3-benzoxazole, 2-benzofuran, 7*H*-purine

Chinolin, Iso-Chinolin, Quinazoline, Quinoxaline, phthalazine

1,2,4-benzotriazine, Pyrido[2,3-*d*]pyrimidine, Pyrido[3,2-*d*]pyrimidine, pteridine

acridine, phenazine, benzo[*g*]pteridine

9*H*-carbazole, Bipyridin & Derivate (0 - 2 $X_i$ / Ring = N)

Schema 1

Gemäß einer Ausführungsform ist die erste Verbindung Tetrakis-Cu(I)perfluorbenzoat, hier und im Folgenden mit der Kurzbezeichnung Cu(I)pFBz bezeichnet, oder Dichrom(II)-tetrakis-trifluoracetat. Prinzipiell können aber auch weitere an sich bekannte Verbindungen als erste Verbindung eingesetzt werden.

Gemäß einer Ausführungsform kann die erste Verbindung aus einer Gruppe ausgewählt sein, die Kupfer(I)-Komplexe wie sie beispielsweise in der US 2011/0089 408 A1 beschrieben sind, Kupfer(II)-Komplexe wie sie beispielsweise in der US 2011/0089 408 A1 beschrieben sind, Kupfer(II)Acetylacetonat wie sie beispielsweise in der DE 10 2010 013 495 A1 beschrieben sind, Metallkomplexe, wie beispielsweise Rhodiumtrifluoroacetat, wie sie beispielsweise-

weise in der DE 10 2007 028 237 A1 und DE 10 2007 028 238 A1 beschrieben sind, umfasst.

Dabei unterscheiden sich die oben beschriebenen Ausführungsformen der ersten Verbindung durch ihre Elektronenakzeptorstärke in Bezug auf das Matrixmaterial und bezogen auf eine gleiche Konzentration der ersten Verbindung in dem Matrixmaterial. Insbesondere ist die erste Verbindung ein Kupfer(I)-Komplex wie sie beispielsweise in der US 2011/0089 408 A1, und ein Rhodiumkomplex, wie beispielweise Rhodiumtrifluoroacetat, wie sie beispielsweise in der DE 10 2007 028 237 A1 und DE 10 2007 028 238 A1 beschrieben sind. Dadurch wird das Erscheinungsbild des optoelektronischen Bauelements im ausgeschalteten Zustand positiv beeinflusst.

Gemäß einer Ausführungsform umfasst die zweite Verbindung einen Aromaten und/oder Heteroaromaten, welcher mindestens zwei funktionelle Gruppen aufweist, die zur Ausbildung einer koordinativen Bindung und/oder $\pi$-$\pi$-Wechselwirkung befähigt sind.

Die $\pi$- $\pi$-Wechselwirkung kann insbesondere zwischen Aromaten unterschiedlicher Akzeptorstärke von erster, zweiter und/oder dem Matrixmaterial ausgebildet werden.

$\pi$-$\pi$-Wechselwirkung sind Kräfte, die zwischen $\pi$-Systemen von Molekülen, beispielsweise $\pi$-Systemen ungesättigter Verbindungen, auftreten und sich durch deren Quadrupolmonente ergeben.

Insbesondere weisen die Aromaten und/oder Heteroaromaten einen Ring oder eine Mehrzahl von Ringen auf. Insbesondere können die Aromaten und/oder Hetereoaromaten 2 bis 6 Ringe, insbesondere 4 Ringe umfassen. Alternativ oder zusätzlich ist der Ring oder die Mehrzahl der Ringe kondensiert.

Insbesondere sind die funktionellen Gruppen aus einer Gruppe ausgewählt, die Amin, Phosphin, Phenol, Thiol, Cyano, Isocyano, Cyanato, Nitrato, Carboxylato, fluoriertes Carboxylato, Acetylacetonat, fluoriertes Acetylacetonat, Carbonyl, Amid, Imid, Thienyl, Fluor und Kombinationen daraus umfasst.

Die funktionellen Gruppen können auch Elektronendonatoren sein.

Gemäß einer Ausführungsform sind die funktionellen Gruppen dazu befähigt koordinative Bindungen auszubilden, welche zu der ersten Verbindung und/oder dem Matrixmaterial ausgebildet werden.

Gemäß einer Ausführungsform weist die zweite Verbindung lochleitende Eigenschaften auf. Die zweite Verbindung kann Löcher beziehungsweise positive Ladungen leiten. Dadurch kann die Leitfähigkeit der organischen funktionellen Schicht erhöht werden. Dies führt zu einem geringeren Spannungsabfall in der organisch funktionellen Schicht und damit zu einer höheren Effizienz des optoelektronischen Bauelements im Vergleich zu einer organischen funktionellen Schicht mit einer geringeren Leitfähigkeit und einem größerem Spannungsabfall, sofern das Ladungsträgergleichgewicht konstant bleibt. Dies bewirkt zusätzlich eine höhere Exzitonendichte in der Strahlung emittierenden Schicht und damit eine höhere Lichtausbeute des optoelektronischen Bauelements.

Gemäß einer Ausführungsform umfasst die zweite Verbindung zumindest einen Heteroaromaten, der zumindest eine der aromatischen Grundstrukturen aus Schema 1 umfasst. Insbesondere sind die funktionellen Gruppen mit zumindest einer aromatischen Grundstruktur aus Schema 1 verknüpft.

Zusätzlich kann die zweite Verbindung eine Konjugation aufweisen, beispielsweise weist die zweite Verbindung alternierende Einfach- und Doppelbindungen auf.

Gemäß einer Ausführungsform umfasst die zweite Verbindung eine Struktureinheit 3

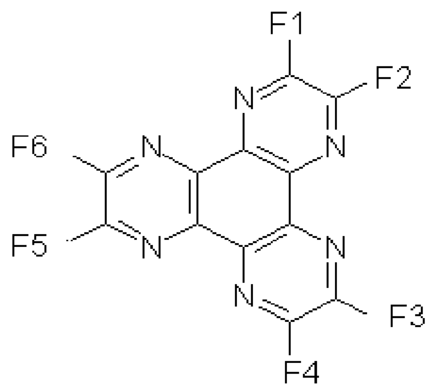

und/oder eine Struktureinheit 4

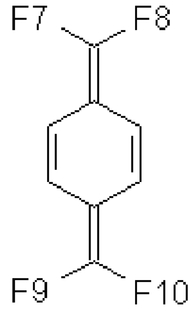

Wobei F1, F2, F3, F4, F5, F6, F7, F8, F9 und/oder F10 gleich oder ungleich sein können, unabhängig voneinander sind und aus einer Gruppe ausgewählt sind, die Amin, Phosphin, Phenol, Thiol, Cyano, Isocyano, Cyanato, Nitrato, Carboxylato, Carbonyl, Amid, Imid, Tienyl, Fluor und Kombinationen daraus umfasst. Insbesondere ist Cyanato bevorzugt.

Alternativ oder zusätzlich können die Struktureinheiten 3 oder 4 an den C-Atomen substituiert sein. Substituenten können aus einer Gruppe ausgewählt werden, die Alkyl, Aryl, Heteroaryl, Cycloalkyl, Fluor umfasst.

Insbesondere ist die zweite Verbindung aus einer Gruppe ausgewählt, die Dipyrazino[2,3-f:2',3'-h]quinoxalin-2,3,6,7,10,11-hexacarbonitril (hier mit der Kurzbezeichnung HAT-CN verwendet), 7,7,8,8-Tetracyanoquionodimethan (hier mit der Kurzbezeichnung TCQ verwendet), 2,3,5,6-Tetrafluoro-7,7,8,8-tetracyanoquinodimethan (hier mit der Kurzbezeichnung FCQ verwendet), 2,3-di(N-phthalimido)-5,6-dicyano-1,4-benzoquinon (hier mit der Kurzbezeichnung PBQ verwendet), Pyrazino[2,3-f][1,10]phenanthroline-2,3-dicarbonitrils und deren fluorierte oder unfluorierte Derivate und Tetracyanonaphthoquinodimethan und deren fluorierten oder unfluorierte Derivate umfasst. Die Formeln von HAT-CN, TCQ, FCQ und PBQ sind im Folgenden gezeigt. Die Pfeile an den Formeln zeigen mögliche Koordinationsstellen, welche befähigt sind, beispielsweise an der ersten Verbindung und/oder an das Matrixmaterial zu koordinieren

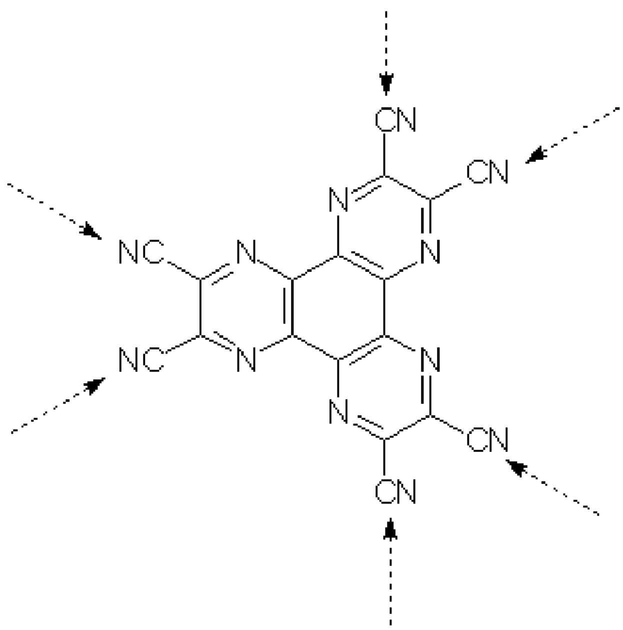

HAT-CN

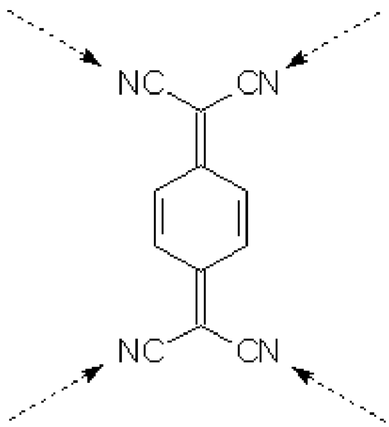

TCQ

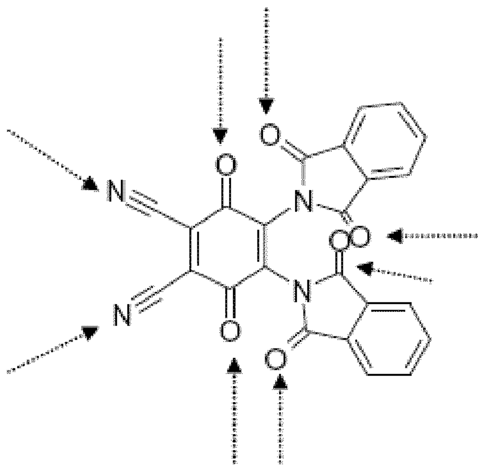

PBQ

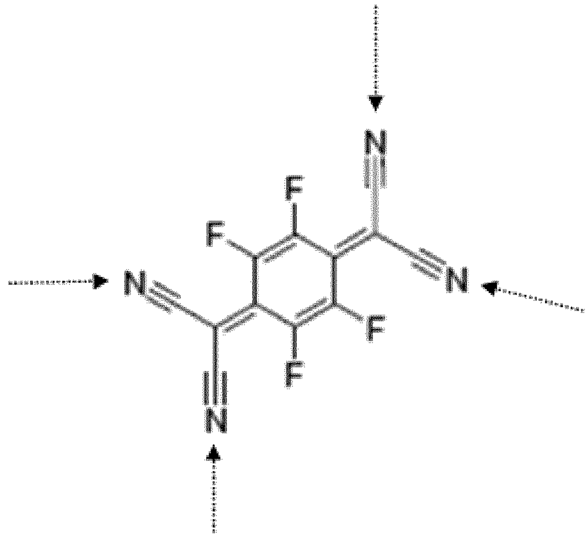

FCQ

Gemäß einer Ausführungsform weist die zweite Verbindung ein $\pi$-Elektronensystem auf, welches zumindest einen Ring, beispielsweise 1 bis 6 Ringe, umfasst. Dadurch können Elektronen der ersten Verbindung und/oder zweiten Verbindung beziehungsweise Löcher im Matrixmaterial lokalisiert werden. Dies resultiert in einer höheren Leitfähigkeit der organischen funktionellen Schicht und führt damit zu einer höheren Lichtausbeute des optoelektronischen Bauelements.

In einer Ausführungsform des optoelektronischen Bauelements koordiniert der Metallkomplex der ersten Verbindung an eine der funktionellen Gruppen oder an eine Mehrzahl der funktionellen Gruppen der zweiten Verbindung. Die Koordination der zweiten Verbindung an das Metallzentralatom der ersten Verbindung kann über die funktionellen Gruppen der zweiten Verbindung oder über ein Atom, beispielsweise N, P, S oder O, im aromatischen System der zweiten Verbindung erfolgen. Bei oder nach der Koordination der ersten Verbindung an die zweite Verbindung wird vorzugsweise keine der zuvor behandelten Liganden des Metallkomplexes abgespalten, es findet also kein Ligandenaustausch statt.

Gemäß einer Ausführungsform bildet die erste Verbindung mit der zweiten Verbindung mehrere koordinative Bindungen so aus, dass eine kettenartige Struktur und/oder eine netzartige Struktur entstehen.

Es können noch zusätzliche Verbindungen in das Matrixmaterial eingebracht werden, welche durch Wechselwirkung mit der ersten Verbindung, zweiten Verbindung und/oder dem Matrixmaterial eine kettenartige und/oder netzartige Struktur, beispielsweise eine dreidimensionale Struktur, bilden.

Gemäß einer Ausführungsform weist die erste Verbindung neben einem Strukturelement "Metallzentralatom" M zumindest ein Strukturelement "freie Koordinationsstelle" $KS_n$ (Index n bezeichnet hierbei die Anzahl der Koordinationsstellen) auf. Die zweite Verbindung weist ein Strukturelement "Aromaten und/oder Heteroaromaten" A und zumindest ein Strukturelement "funktionelle Gruppe" $FG_m$ (Index m bezeichnet hierbei die Anzahl der funktionellen Gruppen) auf. Unter "Strukturelement" versteht man in diesem Zusammenhang einen charakteristischen Bereich der Strukturformel. Beispielsweise umfasst das Strukturelement "funktionelle Gruppe" $FG_n$ alle zuvor behandelten funktionellen Gruppen der zweiten Verbindung. Das Strukturelement "Metallzentralatom" M umfasst die zuvor behandelten Metallzentralatome der ersten Verbindung. Das Strukturelement "freie Koordinationsstelle" $KS_n$ umfasst die zuvor behandelten freien Koordinationsstellen der ersten Verbindung. Das Strukturelement "Aromaten und/oder Heteroaromaten" A umfasst die zuvor behandelten Aromaten und/oder Heteroaromaten der zweiten Verbindung. Zumindest ein Strukturelement "freie Koordinationsstelle", beispielsweise $KS_1$, ist befähigt, mit dem Strukturelement "funktionelle Gruppe", beispielsweise $FG_1$ der zweiten Verbindung zu wechselwirken. Das kann beispielsweise durch Ausbildung von zumindest einer koordinativen Bindung erzeugt werden. Dadurch kann eine kettenartige Struktur und/oder eine netzartige Struktur entstehen (siehe folgende schematische Abbildung).

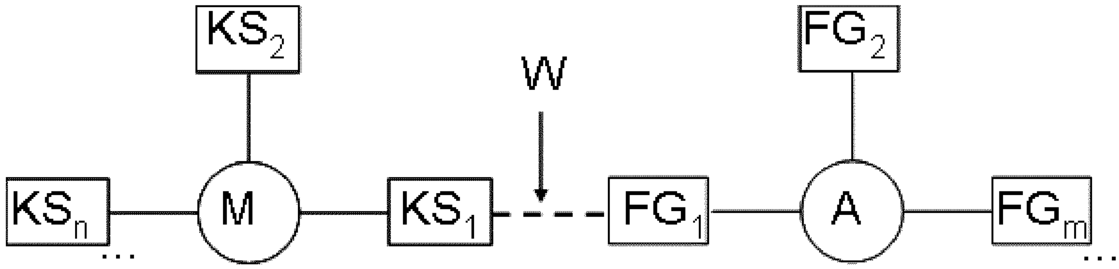


Hier und in diesem Zusammenhang bezeichnen:

M: ein Strukturelement "Metallzentralatom" der ersten Verbindung
$KS_n$ : ein Strukturelement "n-te freie Koordinationsstelle" der ersten Verbindung,
$KS_1$ : ein Strukturelement "erste freie Koordinationsstelle" der ersten Verbindung,
$KS_2$ : ein Strukturelement "zweite freie Koordinationsstelle" der ersten Verbindung,
A: ein Strukturelement "Aromatenund/oder Heteroaromaten" der zweiten Verbindung,
$FG_m$ : ein Strukturelement "m-te funktionelle Gruppe" der zweiten Verbindung,
$FG_1$ : ein Strukturelement "erste funktionelle Gruppe" der zweiten Verbindung,
$FG_2$ : ein Strukturelement "zweite funktionelle Gruppe" der zweiten Verbindung, und
W: Wechselwirkungen zwischen Strukturelement "erster freier Koordinationsstelle" der ersten Verbindung und Strukturelement "erster funktioneller Gruppe" der zweiten Verbindung.

Gemäß einer Ausführungsform kann die erste Verbindung und/oder zweite Verbindung als p-Dotierstoff eingesetzt werden. "p-Dotierstoff" bedeutet in diesem Zusammenhang, dass dieser dazu befähigt ist, Elektronen des Matrixmaterials aufzunehmen und damit Löcher im Matrixmaterial zu erzeugen.

Gemäß einer Ausführungsform ist die organische funktionelle Schicht eine Lochtransportschicht. Die Zugabe einer ersten Verbindung zu einer zweiten Verbindung in einem Matrixmaterial der Lochtransportschicht resultiert, in einer verbesserten Lochtransporteigenschaft verglichen mit dem Matrixmaterial, welches keine erste und zweite Verbindung enthält. Dieser verbesserte Lochtransport kann erklärt werden durch den Transfer der Löcher oder der positiven Ladung von den Molekülen des Matrixmaterials, welche mit der ersten oder zweiten Verbindung wechselwirken können.

Im Folgenden zeigt beispielhaft:

Schema 2: Wechselwirkung der ersten Verbindung am Beispiel Cu(I)pFBz mit der zweiten Verbindung am Beispiel HAT-CN,
Schema 3: Wechselwirkung der ersten Verbindung am Beispiel Cu(I)pFBz mit der zweiten Verbindung am Beispiel HAT-CN, und Wechselwirkung der ersten Verbindung am Beispiel Cu(I)pFBz mit dem Matrixmaterial am Beispiel N,N'-bis(naphthalen-1-yl)-N,N'-bis(phenyl)-benziden (NPD), und
Schema 4: Wechselwirkung der ersten Verbindung am Beispiel Cu(I)pFBz mit der zweiten Verbindung am Beispiel HAT-CN, und Wechselwirkung der zweiten Verbindung am Beispiel HAT-CN mit dem Matrixmaterial am Beispiel NPD. Die Wechselwirkungen sind auf die in den Schemata 1 bis 4 dargestellten Wechselwirkungen oder andere Wechselwirkungen von in den Ausführungsbeispielen beschriebener Verbindungen nicht beschränkt. Vielmehr kann auch ein anderes Ausführungsbeispiel der ersten Verbindung, zweiten Verbindung und/oder des Matrixmaterials genutzt werden. Auch ist es möglich, dass erste Verbindung, zweite Verbindung und/oder das Matrixmaterial über zumindest eine π-π-Wechselwirkung zwischen zwei Aromaten unterschiedlicher Akzeptorstärke wechselwirken, wie es beispielsweise in der DE 10 2007 028 238 A1 und/oder bei Sevryugina et al., Inorg. Chem. 2007, 46, 7870-7879 gezeigt ist.

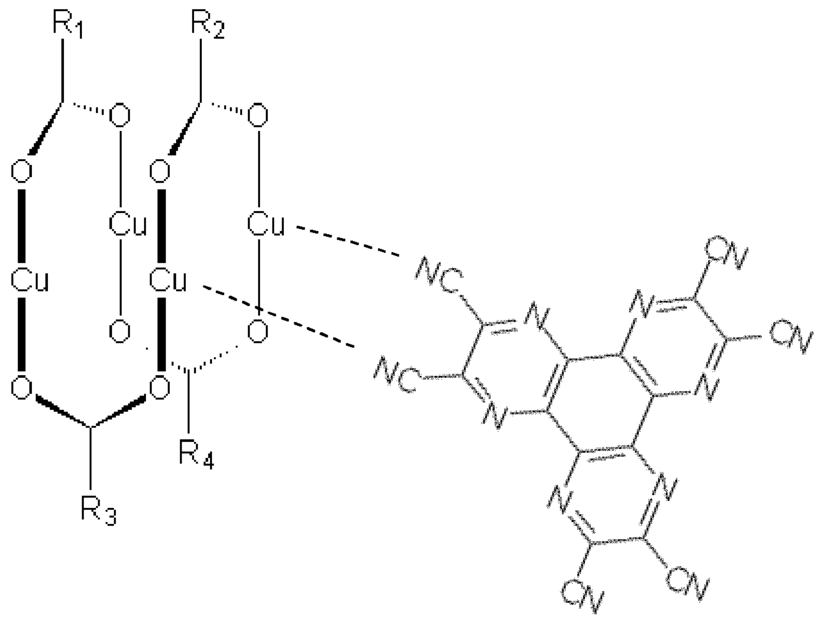

Schema 2

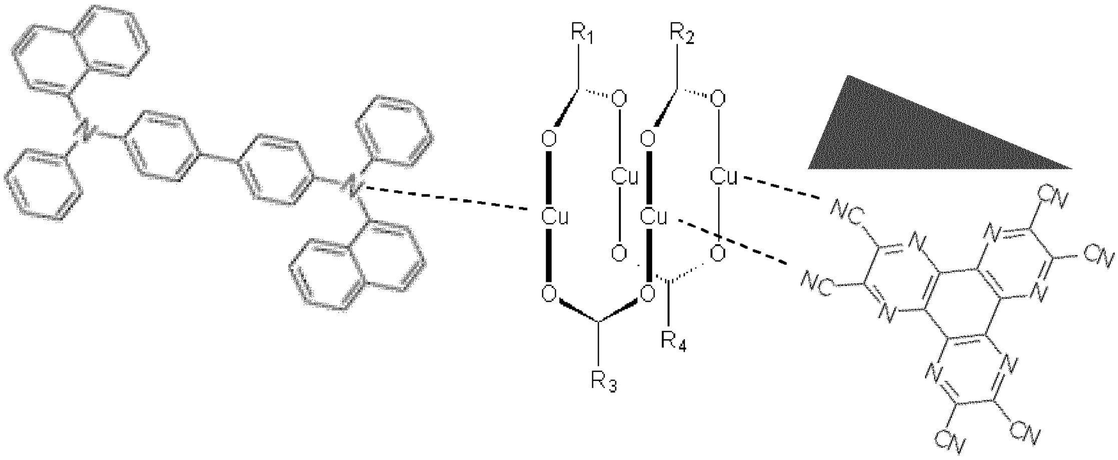

Schema 3

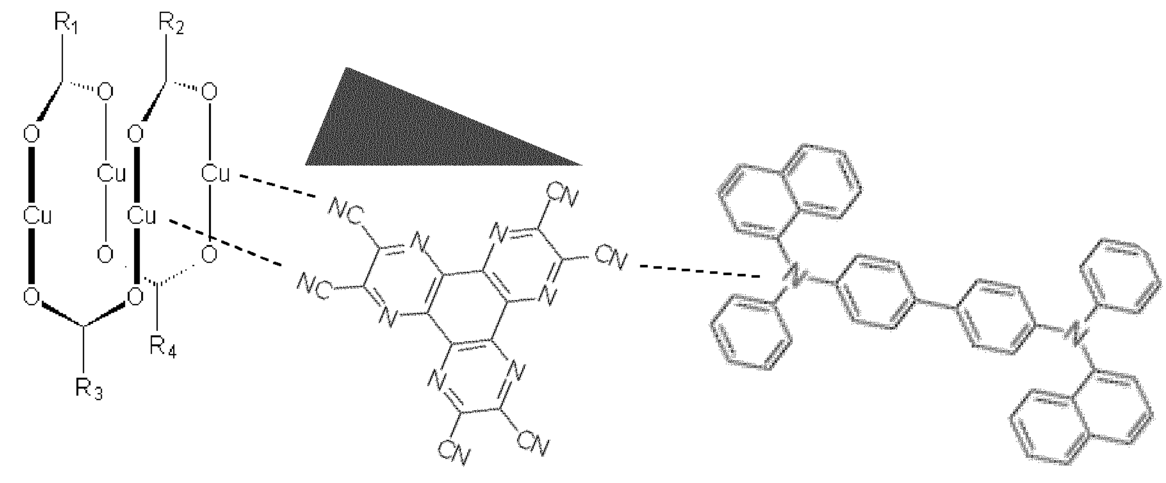

Schema 4

Gemäß einer Ausführungsform wechselwirken nicht alle Moleküle des Matrixmaterials mit den Molekülen der ersten Verbindung und/oder zweiten Verbindung.

Das Matrixmaterial, beispielsweise der Lochtransportschicht, kann aus einer Gruppe ausgewählt werden, die eine oder mehrere Verbindungen der folgenden Gruppen umfasst: NPB (N,N'-bis(naphthalen-1-yl)-N,N'-bis(phenyl)-benzidine, β-NPB (N,N'-bis(naphthalen-2-yl)-N,N'-bis(phenyl)-benzidine), TPD (N,N'-bis(3-methylphenyl)-N,N'-bis(phenyl)-benzidine), N,N'-bis(naphthalen-1-yl)-N,N'-bis (phenyl)-2,2-dimethylbenzidine, Spiro-TPD (N,N'-bis(3-methylphenyl)-N,N'-bis(phenyl)-9,9-spirobifluorene), Spiro-NPB (N,N'-bis(naphthalen-1-yl)-N,N'-bis(phenyl)-9,9-spirobifluorene), DMFL-TPD (N,N'-bis(3-methylphenyl)-N,N'-bis(phenyl)-9,9-dimethylfluorene, DMFL-NPB (N,N'-bis (naphthalen-1-yl)-N,N'-bis(phenyl)-9,9-dimethylfluorene), DPFL-TPD (N,N'-bis(3-methylphenyl)-N,N'-bis(phenyl)-9,9-diphenylfluorene), DPFL-NPB (N,N'-bis(naphth-1-yl)-N,N'-bis(phenyl)-9,9-diphenylfluorene), Sp-TAD (2,2',7,7'-tetrakis(n,n-diphenylamino)-9,9'-spirobifluorene), TAPC (di-[4-(N,N-ditolyl-amino)-phenyl]cyclohexane), Spiro-TTB (2,2',7,7'-tetra(N, N-ditolyl)amino-spiro-bifluorene), BPAPF (9,9-bis[4-(N,N-bis-biphenyl-4-yl-amino)phenyl]-9H-fluorene), Spiro-2NPB (2,2',7,7'-tetrakis[N-naphthyl(phenyl)-amino]-9,9-spirobifluorene), Spiro-5 (2,7-bis[N,N-bis(9,9-spiro-bifluoren-2-yl)-amino]-9,9-spirobifluorene), 2,2'-Spiro-DBP (2,2'-bis[N,N-bis(biphenyl-4-yl)amino]-9,9-spirobifluorene), PAPB (N, N'-bis(phenanthren-9-yl)-N,N'-bis(phenyl)-benzidine), TNB (N, N,N',N'-tetra-naphthalen-2-yl-benzidine), Spiro-BPA (2,2'-bis(N,N-di-phenyl-amino)-9,9-spirobifluorene), NPAPF (9,9-Bis[4-(N,N-bis-naphth-2-yl-amino)phenyl]-9H-fluorene), NPBAPF (9,9-bis[4-(N, N'-bis-naphth-2-yl-N,N'-bis-phenyl-amino)-phenyl]-9H-fluorene), TiOPC (titanium oxide phthalocyanine), CuPC (copper phthalocyanine), F4-TCNQ (2,3,5,6-tetrafluor-7,7,8,8,-tetracyano-quinodimethane), m-MTDATA (4,4',4" -tris(N-3-methylphenyl-N-phenyl-amino)triphenylamine), 2T-NATA (4,4',4" -tris(N-(naphthalen-2-yl)-N-phenyl-amino)triphenylamine), 1T-NATA (4,4',4" -tris(N-(naphthalen-1-yl)-N-phenyl-amino)triphenylamine), NATA (4,4',4" -tris(N,N-diphenyl-amino)triphenylamine), PPDN (pyrazino[2,3-f][1,10]phenanthroline-2,3-dicarbonitrile), MeO-TPD (N, N, N' , N' -tetrakis(4-methoxyphenyl)benzidine), MeO-Spiro-TPD (2,7-bis[N,N-bis(4-methoxy-phenyl)amino]-9,9-spirobifluorene), 2,2'-MeO-Spiro-TPD (2,2'-bis[N,N-bis(4-methoxy-phenyl)amino]-9,9-spirobifluorene), β - NPP (N, N'-di(naphthalen-2-yl)-N,N'-diphenylbenzene-1,4-diamine), NTNPB (N,N'-di-phenyl-N,N'-di-[4-(N, N-di-tolyl-amino)phenyl]benzidine) und NPNPB (N,N'-di-phenyl-N,N'-di-[4-(N, N-di-phenyl-amino)phenyl]benzidine). Die Auflistung ist aber keinesfalls beschränkt. Jedes Matrixmaterial, welches gewöhnlich Löcher transportiert, ist als Bestandteil der organischen funktionellen Schicht geeignet.

Gemäß einer Ausführungsform beträgt der Anteil des Matrixmaterials in der organischen funktionellen Schicht mehr als 50 %, bevorzugt mehr als 80 %, besonders bevorzugt mehr als 90 %, beispielsweise 95%.

In einer weiteren Ausführungsform ist die organische funktionelle Schicht eine elektronenblockierende Schicht.

Die organische funktionelle Schichtumfasst das Matrixmaterial, die erste Verbindung, die zweite Verbindung, wobei die erste Verbindung mit der zweiten Verbindung über zumindest eine koordinative Bindung einen Elektronendonator-Elektronenakzeptor-Komplex ausbildet, und wobei die erste Verbindung und/oder die zweite Verbindung als Elektronenakzeptor mit dem Matrixmaterial wechselwirkt, und wobei durch die Wechselwirkung im Elektronendonator-Elektronenakzeptor-Komplex eine Leitfähigkeit der organischen funktionellen Schicht erzeugt wird.

Beispielsweise ist die Leitfähigkeit der organischen funktionellen Schicht größer als eine Summe aus einer ersten Leitfähigkeit, welche durch alleinige Wechselwirkung der ersten Verbindung mit dem Matrixmaterial erzeugt wird, und einer zweiten Leitfähigkeit, welche durch alleinige Wechselwirkung der zweiten Verbindung mit dem Matrixmaterial

erzeugt wird.
Beispielsweise ist die organische funktionelle Schicht Bestandteil einer organischen Leuchtdiode, eines Transistors, beispielsweise eines Feldeffekttransistors, einer Solarzelle oder eines Fotodetektors.

Es wird weiterhin ein Verfahren zur Herstellung eines optoelektronischen Bauelements angegeben, welches folgende Verfahrensschritte umfasst:

A) Bereitstellen eines Substrats,

B) Aufbringen einer ersten Elektrode,

C) Abscheiden zumindest einer organischen funktionellen Schicht oder einer Mehrzahl von organischen funktionellen Schichten auf dem Substrat,

D) Aufbringen einer zweiten Elektrode,

wobei das Abscheiden der organischen funktionellen Schicht durch gleichzeitiges Verdampfen aus unterschiedlichen Quellen einer ersten Verbindung, einer zweiten Verbindung und eines Matrixmaterials erfolgt.

Das Abscheiden der organischen funktionellen Schicht durch gleichzeitiges Verdampfen aus unterschiedlichen Quellen einer ersten Verbindung, einer zweiten Verbindung und eines Matrixmaterials verursacht eine höhere Leitfähigkeit der organischen funktionellen Schicht. Insbesondere bei Verwendung einer organischen funktionellen Schicht, welche eine Dicke von 5 nm bis 600 nm, bevorzugt 100 bis 400 nm aufweist, zur Reduzierung der Anfälligkeit eines elektrischen Kurzschlusses im optoelektronischen Bauelement, beispielsweise in großflächigen OLEDs, kann der vertikale Spannungsabfall über die organische funktionelle Schicht weiter reduziert werden und damit Effizienz und Lichtausbeute des optoelektronischen Bauelements gesteigert werden. Zusätzlich kann die laterale Stromverteilung des optoelektronischen Bauelements verbessert werden, wenn die Leitfähigkeit der organischen funktionellen Schicht in der Größenordnung der Leitfähigkeit der ersten Elektrode und/oder zweiten Elektrode, beispielsweise von Indium Tin Oxide = zinnoxiddotiertes Indiumoxid (ITO), liegt.

Alternativ oder zusätzlich kann im Verfahrensschritt D zumindest die erste und zweite Verbindung vor dem Verdampfen gemischt werden, wobei das Abscheiden der organischen funktionellen Schicht durch gleichzeitiges Verdampfen aus einer Quelle der ersten und zweiten Verbindungen und einer anderen Quelle des Matrixmaterials erfolgt.

Für das Verfahren zur Herstellung eines optoelektronischen Bauelements gelten die gleichen Definitionen und Ausführungen wie sie vorstehend in der Beschreibung für ein optoelektronisches Bauelement angegeben wurden.

Gemäß einer Ausführungsform kann die Anzahl der koordinativen Bindungen zwischen der ersten organischen Verbindung und der zweiten organischen Verbindung und/oder der ersten organischen Verbindung und dem Matrixmaterial und/oder der zweiten organischen Verbindung und dem Matrixmaterial durch Konzentrationsänderung beim Verdampfen gesteuert werden.

Im Folgenden sollen weitere Vorteile und vorteilhafte Ausführungsformen und Weiterbildung des erfindungsgemäßen Gegenstandes anhand von Figuren und Ausführungsbeispielen näher erläutert werden.

Die Figuren zeigen:

Figur 1 die schematische Seitenansicht eines optoelektronischen Bauelements,

Figur 2 die Konzentrationsabhängigkeit der spezifischen Leitfähigkeit K von Vergleichsbeispielen und gemäß einer erfindungsgemäßen Ausführungsform,

Figur 2a die Messgeometrie einer organischen Teststruktur,

Figur 3 die spezifische Leitfähigkeit K durch Wechselwirkung einer ersten Verbindung und einer zweiten Verbindung gemäß einer weiteren Ausführungsform im Vergleich zu Vergleichsbeispielen.

In den Ausführungsbeispielen und Figuren sind gleiche oder gleichwirkende Bestandteile jeweils mit den gleichen Bezugszeichen versehen. Die dargestellten Elemente und deren Größenverhältnisse untereinander sind grundsätzlich nicht als maßstabsgerecht anzusehen. Weiterhin sind gleiche Ausführungsbeispiele von erster und zweiter Verbindung und Matrixmaterial mit den gleichen Kurzbezeichnungen versehen.

Figur 1 zeigt eine schematische Seitenansicht eines optoelektronischen Bauelements am Ausführungsbeispiel einer organischen Leuchtdiode (OLED). Die OLED umfasst ein Substrat 1, das sich ganz unten befindet und beispielsweise transparent sein kann und aus Glas sein kann. Auf dem Substrat 1 ist eine erste Elektrode 2 angeordnet, welche als Schicht ausgeformt sein kann, und beispielsweise ein transparentes leitendes Oxid wie beispielsweise Zinkoxid,

Zinnoxid, Kadmiumoxid, Titanoxid, Indiumoxid oder Indiumzinnoxid (ITO) sein kann. Über dieser Elektrodenschicht 2 befindet sich eine Lochinjektionsschicht 3, über der wiederum die Lochtransportschicht 4 angeordnet ist. Darauf befindet sich eine Strahlung emittierende Schicht, welche beispielsweise mehrere einzelne Schichten aufweisen kann. Auf der Strahlung emittierenden Schicht 5 liegt die lochblockierende Schicht 6, auf der die Elektronentransportschicht 7 und schließlich die Elektroneninjektionsschicht 8 mit angrenzender zweiter Elektrode 9 angeordnet sein kann. Die zweite Elektrode 9 kann beispielsweise eine Metallelektrode oder eine weitere transparente Elektrode, zum Beispiel aus einem der vorstehend genannten transparenten leitenden Oxide sein. Beispielsweise ist die erfindungsgemäße organische funktionelle Schicht die Lochinjektionsschicht, Lochtransportschicht, Lochblockierungsschicht oder Strahlung emittierende Schicht.

Wird zwischen der ersten Elektrode 2 und der zweiten Elektrode 9 eine Spannung angelegt, so fließt Strom durch das optoelektronische Bauelement. Dabei werden von der einen Elektrode, der Kathode, Elektronen in die Elektroneninjektionsschicht 8 injiziert und von der anderen Elektrode, der Anode, so genannte Löcher. In der Strahlung emittierenden Schicht 5 rekombinieren die Löcher und Elektronen, wobei Elektronenlochpaare, so genannte Exzitonen, entstehen und zur Emission von elektromagnetischer Strahlung fähig sind.

Alternativ ist ein optoelektronisches Bauelement (hier nicht gezeigt) in Form einer OLED mit Substrat 1, erster Elektrode 2, organischer funktioneller Schicht und zweiter Elektrode 9 ausgeformt.

Alternativ ist eine Anordnung eines optoelektronischen Bauelements (hier nicht gezeigt) in Form einer OLED aus Substrat 1, erster Elektrode 2, Lochinjektionsschicht 3, Elektronentransportschicht 5 und zweiter Elektrode 9 möglich.

Alternativ oder zusätzlich ist die erste und zweite Verbindung in dem Matrixmaterial als Folie oder als Verguss ausgeformt und auf oder über der ersten Elektrode angeordnet oder aufgebracht(hier nicht gezeigt).

Alternativ ist es möglich, die Lochinjektionsschicht 3, die Lochtransportschicht 4 oder die Strahlung emittierende Schicht 5 als organische funktionelle Schicht auszuformen, wobei die organische funktionelle Schicht die erste Verbindung und zweite Verbindung in einem Matrixmaterial umfasst.

Die organische funktionelle Schicht gemäß der vorliegenden Erfindung kann hierbei jede Schicht sein, in der Löcher transportiert werden. Vorzugsweise handelt es sich bei der organischen funktionellen Schicht gemäß der Erfindung um die Lochinjektionsschicht 3 oder Lochtransportschicht 4. Bei der organischen funktionellen Schicht kann es sich beispielsweise aber auch um die Strahlung emittierende Schicht 5 handeln, so zum Beispiel, dass mit der ersten Verbindung und der zweiten Verbindung noch ein weiteres Strahlung emittierendes Material verdampft wird. Alternativ kann das Strahlung emittierende Material aber auch auf anderem Wege in die Strahlung emittierende Schicht 5 eingebracht werden. Durch die verbesserte Lochtransportfähigkeit können mehr Löcher und Elektronen rekombinieren, sodass mehr Exzitonen (Elektronenlochpaare) gebildet werden. Dadurch erhöht sich die Exzitonendichte in der Strahlung emittierenden Schicht 5, wobei die Leuchtdichte und Effizienz des optoelektronischen Bauelements erhöht wird.

Hier und im Folgenden werden folgende Kurzbezeichnungen für Vergleichsbeispiele von erster Verbindung oder zweiter Verbindung im Matrixmaterial verwendet:

V1:: Vergleichsbeispiel einer ersten Verbindung Cu(I)pFBz im Matrixmaterial HTM-014 der Firma Merck

V8: Vergleichsbeispiel einer zweiten Verbindung HAT-CN im Matrixmaterial HTM-014, und

A1 : Ausführungsbeispiel einer ersten Verbindung Cu(I)pFBz mit einem festen Anteil von 5% und einer zweiten Verbindung HAT-CN mit einem variablen Anteil in dem Matrixmaterial HTM-014.

Figur 2 zeigt die spezifische Leitfähigkeit K in Siemens pro Meter (S x $m^{-1}$) von Vergleichsbeispielen V1 und V8, sowie von dem Ausführungsbeispiel A1 in Abhängigkeit von der in Volumenprozent angegebenen Konzentration c der ersten Verbindung Cu(I)pFBz oder der zweiten Verbindung HAT-CN. Dabei wurde eine organische Teststruktur zur Leitfähigkeitsmessung nach Figur 2a verwendet. Dabei bezeichnet in Figur 2a d - Dicke der organischen Teststruktur, L - Länge der organischen Teststruktur, S - Breite der organischen Teststruktur, K1 - erster Kontakt, K2 - zweiter Kontakt. Zwischen den Kontakten K1 und K2 wird eine Spannung angelegt, wodurch sich ein homogenes elektrisches Feld F im Halbleiter ausbildet. Die spezifische Leitfähigkeit K ergibt sich dann nach folgender Gleichung:

$$K = \frac{j}{F} = \frac{j \cdot S}{U} = \frac{I \cdot S}{U \cdot L \cdot d}$$

mit j - Stromdichte und U - Spannung.

Auf einer ITO (Indium Tin Oxide = zinnoxiddotiertes Indiumoxid) -Elektrode wurde durch gleichzeitiges thermisches Verdampfen aus unterschiedlichen Quellen das jeweilige Matrixmaterial, die erste Verbindung und die zweite Verbindung als eine insgesamt 120 nm dicke organische funktionelle Schicht abgeschieden. Aus der Stromspannungskennlinie wurde die spezifische Leitfähigkeit K berechnet und in Figur 2 beziehungsweise Figur 3 grafisch dargestellt.

Das Matrixmaterial zeigt eine relativ schlechte spezifische Leitfähigkeit von K kleiner $10^{-6}$ S x $m^{-1}$ (hier nicht gezeigt). Durch Verdampfen der ersten Verbindung oder zweiten Verbindung in dem Matrixmaterial kann jedoch eine spezifische Leitfähigkeit K von deutlich größer als $10^{-6}$ S x $m^{-1}$ erreicht werden. Die erste Verbindung Cu(I)pFBz in dem Matrixmaterial HTM-014 (V1) erzeugt eine höhere spezifische Leitfähigkeit K als die zweite Verbindung HAT-CN in dem Matrixmaterial HTM-014 (V8). Bei gleicher Konzentration ergibt sich für das Vergleichsbeispiel V1 für Cu(I)pFBz in HTM-014 eine um zwei Größenordnungen höhere spezifische Leitfähigkeit K im Vergleich zu V8 umfassend HAT-CN in HTM-014. Mit steigender Konzentration der ersten Verbindung Cu(I)pFBz oder zweiten Verbindung HAT-CN ist eine Erhöhung der spezifischen Leitfähigkeit K zu beobachten. Dies resultiert aus Wechselwirkungen der ersten Verbindung Cu(I)pFBz oder zweiten Verbindung HAT-CN mit dem jeweiligen Matrixmaterial. Dadurch werden eine hohe Lochbeweglichkeit und ein Ladungstransfer ermöglicht und die Lichtausbeute des optoelektronischen Bauelements verbessert.

Hier und im Folgenden werden folgende Kurzbezeichnungen für Ausführungsbeispiele und Vergleichsbeispiele von erster Verbindung und/oder zweiter Verbindung im Matrixmaterial verwendet:

V9: Vergleichsbeispiel einer zweiten Verbindung HAT-CN mit einem Anteil von 10% in dem Matrixmaterial HTM-014,
V10: Vergleichsbeispiel einer ersten Verbindung Cu(I)pFBz mit einem Anteil von 5% in dem Matrixmaterial HTM-014,
A1 : Ausführungsbeispiel einer ersten Verbindung Cu(I)pFBz mit einem Anteil von 5% und einer zweiten Verbindung HAT-CN mit einem Anteil von 10% in dem Matrixmaterial HTM-014, und
V11: Vergleichsbeispiel einer ersten Verbindung Cu(I)pFBz mit einem Anteil von 5% in dem Matrixmaterial HTM-014. "Anteil" bezeichnet in diesem Zusammenhang Volumenprozent der ersten Verbindung oder der zweiten Verbindung bezogen auf das Matrixmaterial.

Figur 3 zeigt die spezifische Leitfähigkeit K in Siemens pro Meter (S x $m^{-1}$) von V9, V10, A1 und V11. Die spezifische Leitfähigkeit K von V9 liegt in der Größenordnung von $10^{-5}$ S/m, während die spezifische Leitfähigkeit K von V10 beziehungsweise V11 um eine Größenordnung höher liegt (K=$10^{-4}$ S/m). Erstaunlicherweise ist die spezifische Leitfähigkeit K von A1 nochmals um fast eine Größenordnung (zirka $10^{-3}$ S/m) erhöht. Die spezifische Leitfähigkeit K der organischen funktionellen Schicht wird durch den Zusatz der ersten Verbindung und der zweiten Verbindung in dem Matrixmaterial deutlich erhöht im Gegensatz zu der spezifischen Leitfähigkeit K, welche durch alleinige Wechselwirkung der ersten Verbindung mit dem Matrixmaterial erzeugt wird (V10 oder V11), und der spezifischen Leitfähigkeit K, welche durch alleinige Wechselwirkung der zweiten Verbindung mit dem Matrixmaterial erzeugt wird (V9). Die spezifische Leitfähigkeit K von A1 entsteht durch ein vorteilhaftes Netzwerk der ersten Verbindung Cu(I)pFBz und der zweiten Verbindung HAT-CN in dem Matrixmaterial HTM-014. Bei der Verdampfung von Cu(I)pFBz und HAT-CN findet dabei keine Querkontamination der Materialien in den Quellen statt. Dies zeigen in Figur 3 die nahezu identischen spezifischen Leitfähigkeiten K von V10 und V11, die vor beziehungsweise nach A1 hergestellt wurden.

Synthese von Kupfer(I)Pentafluorobenzoat

Zu $Cu_2O$ (0,451 g, 3,15 mmol) werden 2 ml $(CF_3CO)\ _2O$ gegeben, gefolgt von 30 ml Benzol. Die Mischung wird über Nacht unter Rückfluss erhitzt, wobei eine blaue Lösung erhalten wird und etwas nicht umgesetztes Ausgangsmaterial. Diese Suspension wird mittels Celiter filtriert, um $Cu_2O$ zu entfernen. Die blaue Lösung wird dann bis zur Trockene eingedampft, wobei ein sehr blassblauer Feststoff entsteht. Das gewünschte Produkt wird erhalten, indem bei 60 °C bis 70 °C unter Vakuum für zehn bis 15 Stunden gearbeitet wird. Die Ausbeute beträgt 64 %. Das kristalline Material kann durch Sublimation des rohen Feststoffes bei 110°C bis 120°C gewonnen werden.

Das Reaktionsprodukt (0,797 g, 1,1 mmol) wird mit pentafluorierter Benzoesäure (0,945 g, 6,76 mmol) in einem Schlenkkolben in einer Glovebox aufbewahrt, wobei 55 ml Benzol zur Mischung dazugegeben wird. Eine homogene lichtblaue Lösung wird unter Rückfluss über Nacht erhitzt und dann bis zur Trockne eingedampft, wobei ein hellblauer Feststoff erhalten wird. Es wird bei 90 °C bis 100 °C unter Vakuum für mehrere Tage gearbeitet, um den Überschuss an nicht umgesetzter Benzoesäure zu entfernen. Ein luftstabiler farbloser Feststoff wird durch Sublimationsabscheidung des rohen Pulvers bei 220°C nach einer Woche erhalten. Die Ausbeute des Kupfer(I)Pentafluorobenzoats beträgt 65 %.

Herstellung der organischen funktionellen Schicht

Die in jeweils unterschiedlichen Quellen befindliche erste Verbindung (zum Beispiel Cu(I)pFBz), zweite Verbindung (zum Beispiel HAT-CN) und das Matrixmaterial (zum Beispiel HMT-014) werden auf ihre jeweiligen Sublimationspunkte thermisch erhitzt, wobei diese Verbindungen gleichzeitig verdampft werden. Dabei werden die erste Verbindung, die zweite Verbindung und das Matrixmaterial als organische funktionelle Schicht auf einer ersten Elektrode, beispielsweise ITO, aufgebracht.

Herstellung eines optoelektronischen Bauelements

Die hergestellte organische funktionelle Schicht kann auf einem bereitgestellten Substrat, beispielsweise Glas, auf dem eine erste Elektrode aufgebracht wurde, abgeschieden werden, wobei darauf eine zweite Elektrode aufgebracht wird.

Die Erfindung ist nicht durch die Beschreibung anhand der Ausführungsbeispiele oder angegebenen Merkmalskombinationen beschränkt sondern nur durch die Ansprüche.

## Patentansprüche

**1.** Optoelektronisches Bauelement umfassend,

- ein Substrat (1)
- eine erste Elektrode (2),
- eine zweite Elektrode (9),
- zumindest eine organische funktionelle Schicht, die zwischen erster Elektrode (2) und zweiter Elektrode (9) angeordnet ist und
- ein Matrixmaterial,
- eine erste Verbindung, und
- eine zweite Verbindung umfasst,

wobei die erste Verbindung mit der zweiten Verbindung wechselwirkt, und
wobei die erste Verbindung und/oder die zweite Verbindung mit dem Matrixmaterial wechselwirkt, **dadurch gekennzeichnet, dass**
durch die Wechselwirkungen eine Leitfähigkeit der organischen funktionellen Schicht erzeugt wird, und wobei

- zumindest eine koordinative Bindung der ersten Verbindung mit der zweiten Verbindung und zumindest eine koordinative Bindung der ersten Verbindung mit dem Matrixmaterial gebildet wird oder wobei
- zumindest eine koordinative Bindung der ersten Verbindung mit der zweiten Verbindung gebildet wird und zumindest eine koordinative Bindung der zweiten Verbindung mit dem Matrixmaterial gebildet wird.

**2.** Optoelektronisches Bauelement nach Anspruch 1,
wobei die organische funktionelle Schicht aus einer Gruppe ausgewählt ist, die eine Lochtransportschicht, eine Lochinjektionsschicht und eine Lochblockierungsschicht umfasst.

**3.** Optoelektronisches Bauelement nach einem der vorhergehenden Ansprüche, wobei die erste Verbindung aus einer Gruppe ausgewählt ist, die folgende Struktureinheiten oder Formeln umfasst:

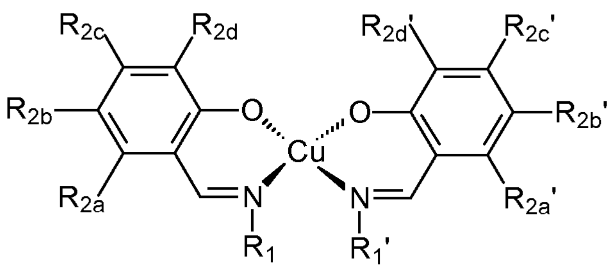

,

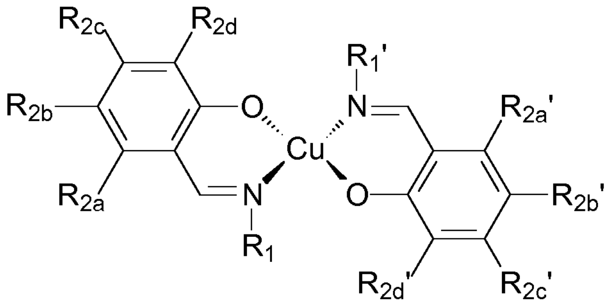

,

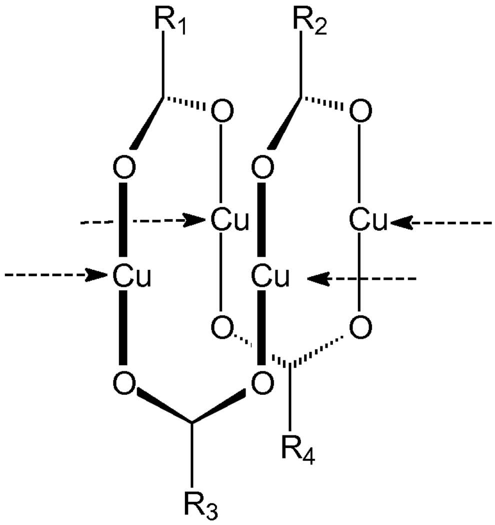

,

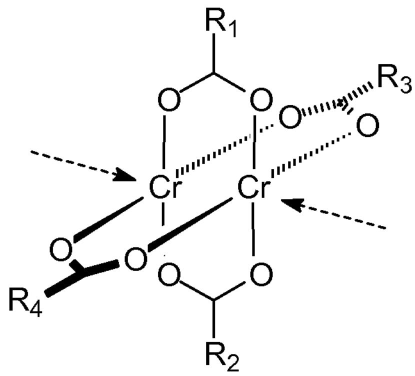

wobei $R_1$, $R_{1'}$, $R_{2x}$ und $R_{2x'}$ unabhängig voneinander aus einer Gruppe ausgewählt sind, die unverzweigte, verzweigte, kondensierte, ringförmige, unsubstituierte und substituierte Alkylreste, substituierte und unsubstituierte Aromaten, substituierte und unsubstituierte Heteroaromaten umfasst, wobei x jeweils für a, b, c oder d steht,

wobei $R_1$, $R_2$, $R_3$ und/oder $R_4$ gleich oder ungleich und jeweils aus einer Gruppe ausgewählt sind, die substituierte oder unsubstituierte Kohlenwasserstoffreste, Alkyl-Reste, Cyclo-Alkylreste, Heterocyclo-Alkyl-Reste, Aryl-Reste, Heteroaryl-Reste und Kombinationen daraus umfasst, und

wobei die zweite Verbindung aus einer Gruppe ausgewählt ist, die Dipyrazino[2,3-f:2',3'-h]quinoxalin-2,3,6,7,10,11-hexacarbonitril, 7,7,8,8-Tetracyanoquionodimethan, 2,3,5,6-Tetrafluoro-7,7,8,8-tetracyanoquinodimethan, 2,3-di(N-phthalimido)-5,6-dicyano-1,4-benzoquinon, Pyrazino[2,3-f] [1,10]phenanthroline-2,3-dicarbonitril und deren fluorierte oder unfluorierte Derivate und Tetracyanonaphthoquinodimethan und deren fluorierten oder unfluorierte Derivate umfasst.

**4.** Optoelektronisches Bauelement nach einem der vorhergehenden Ansprüche, wobei die erste Verbindung ein Elektronenakzeptor in Bezug auf das Matrixmaterial und/oder ein Elektronenakzeptor in Bezug auf die zweite Verbindung

ist.

5. Optoelektronisches Bauelement nach einem der vorhergehenden Ansprüche, wobei die zweite Verbindung ein Elektronenakzeptor in Bezug auf das Matrixmaterial und/oder ein Elektronendonator in Bezug auf die erste Verbindung ist.

6. Optoelektronisches Bauelement nach einem der vorhergehenden Ansprüche, wobei die erste Verbindung einen Metallkomplex mit mindestens einem Metallzentralatom umfasst.

7. Optoelektronisches Bauelement nach dem vorhergehenden Anspruch, wobei das Metallzentralatom der ersten Verbindung ausgewählt ist aus Cu, Cr, Mo und Bi.

8. Optoelektronisches Bauelement nach einem der vorhergehenden Ansprüche, wobei die zweite Verbindung einen Aromaten und/oder Heteroaromaten umfasst, welcher mindestens zwei funktionelle Gruppen aufweist, die zur Ausbildung einer koordinativen Bindung und/oder $\pi$-$\pi$ Wechselwirkung befähigt sind.

9. Optoelektronisches Bauelement nach dem vorherigen Anspruch, wobei die funktionellen Gruppen aus einer Gruppe ausgewählt sind, die Amin, Phosphin, Phenol, Thiol, Cyano, Iso-Cyano, Cyanato, Nitrato, Carboxylato, fluoriertes Carboxylato, Acetylacetonat, fluoriertes Acetylacetonat, Carbonal, Amid, Imid, Thienyl, Fluor und Kombinationen daraus umfasst.

10. Optoelektronisches Bauelement nach einem der vorhergehenden Ansprüche, wobei die erste Verbindung mit der zweiten Verbindung zumindest eine koordinative Bindung ausbildet, so dass eine kettenartige Struktur und/oder eine netzartige Struktur entstehen.

11. Verfahren zur Herstellung eines optoelektronischen Bauelements nach Anspruch 1, umfassend die Verfahrensschritte:

A) Bereitstellen eines Substrats (1)
B) Aufbringen einer ersten Elektrode (2)
C) Abscheiden zumindest einer organischen funktionellen Schicht oder einer Mehrzahl von organischen funktionellen Schichten auf dem Substrat
D) Aufbringen einer zweiten Elektrode (9),

wobei das Abscheiden der organischen funktionellen Schicht durch gleichzeitiges Verdampfen aus unterschiedlichen Quellen einer ersten Verbindung und einer zweiten Verbindung und eines Matrixmaterials erfolgt.

12. Verfahren zur Herstellung eines optoelektronischen Bauelements nach vorherigem Anspruch, wobei durch Wechselwirkung der ersten Verbindung mit der zweiten Verbindung in der Gasphase ein Elektronendonator-Elektronenakzeptor-Komplex ausgebildet wird.

**Claims**

1. Optoelectronic component comprising

- a substrate (1),
- a first electrode (2),
- a second electrode (9),

  - at least one organic functional layer which is arranged between first electrode (2) and second electrode (9) and comprises

- a matrix material,
- a first compound, and
- a second compound,

wherein the first compound interacting with the second compound, and

wherein the first compound and/or the second compound interacting with the matrix material, **characterized in that** the interactions generating a conductivity in the organic functional layer, and
wherein at least one coordinate bond of the first compound with the second compound and at least one coordinate bond is formed by the first compound with the matrix material or wherein

- at least one coordinate bond of the first compound with the second compound and at least one coordinate bond is formed by the second compound with the matrix material.

**2.** Optoelectronic component according to claim 1, wherein the organic functional layer being selected from a group which comprises a hole transport layer, a hole injection layer, and a hole blocking layer.

**3.** Optoelectronic component according to either of the preceding claims, wherein the first compound being selected from a group which comprises the following structural units or formulae:

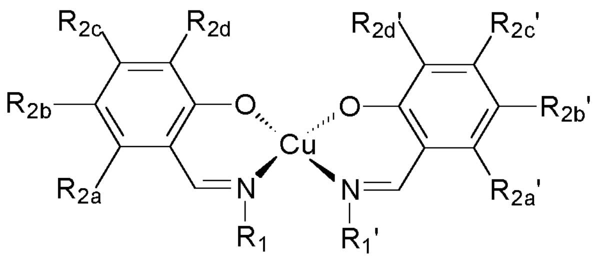

,

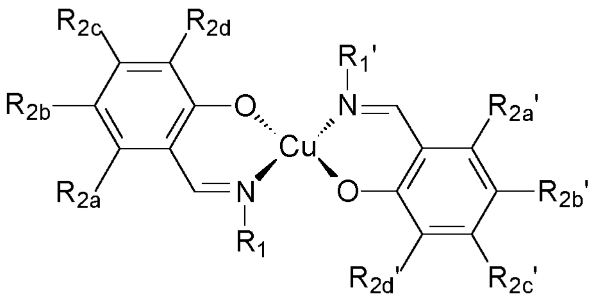

,

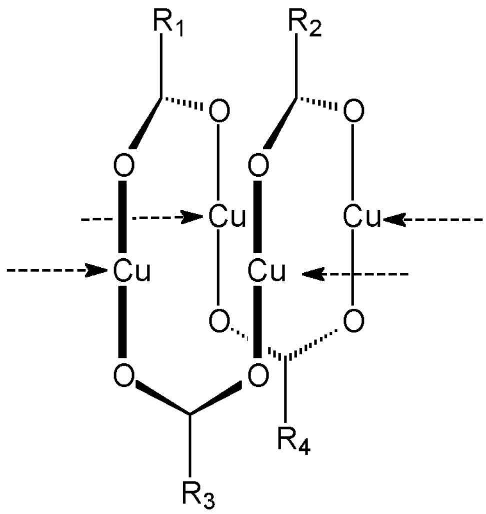

,

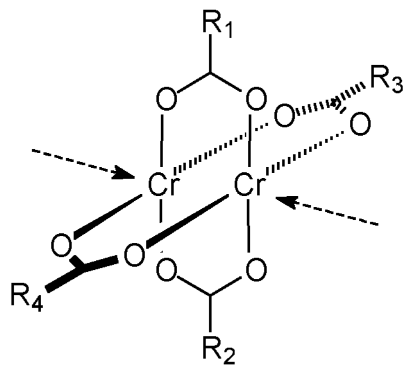

wherein $R_1$, $R_{1'}$, $R_{2x}$ and $R_{2x'}$ independently of one another are selected from a group which comprises unbranched, branched, fused, cyclic, unsubstituted and substituted alkyl radicals, substituted and unsubstituted aromatics, substituted and unsubstituted heteroaromatics, wherein x in each case is a, b, c or d,
wherein $R_1$, $R_2$, $R_3$ and/or $R_4$ are identical or unidentical and are each selected from a group which comprises substituted or unsubstituted hydrocarbon radicals, alkyl radicals, cycloalkyl radicals, heterocycloalkyl radicals, aryl radicals, heteroaryl radicals, and combinations thereof,
and
wherein the second compound is selected from a group which comprises dipyrazino[2,3-f:2',3'-h]quinoxaline-2,3,6,7,10,11-hexacarbonitrile, 7,7,8,8-tetracyanoquiono-dimethane, 2,3,5,6-tetrafluoro-7,7,8,8-tetracyanoquinodimethane, 2,3-di(N-phthalimido)-5,6-dicyano-1,4-benzoquinone, pyrazino[2,3-f][1,10]phenanthroline-2,3-dicarbonitrile and fluorinated or unfluorinated derivatives thereof, and tetracyanonaphthoquinodimethane and fluorinated or unfluorinated derivatives thereof.

**4.** Optoelectronic component according to any of the preceding claims, wherein the first compound being an electron acceptor in relation to the matrix material and/or an electron acceptor in relation to the second compound.

**5.** Optoelectronic component according to any of the preceding claims, wherein the second compound being an electron acceptor in relation to the matrix material and/or an electron donor in relation to the first compound.

**6.** Optoelectronic component according to any of the preceding claims, wherein the first compound comprising a metal complex having at least one central metal atom.

**7.** Optoelectronic component according to the preceding claim, wherein the central metal atom of the first compound being selected from Cu, Cr, Mo and Bi.

**8.** Optoelectronic component according to any of the preceding claims, wherein the second compound comprising an aromatic and/or heteroaromatic which has at least two functional groups which are capable of forming a coordinate bond and/or of $\pi$-$\pi$ interaction.

**9.** Optoelectronic component according to the preceding claim, wherein the functional groups being selected from a group which comprises amine, phosphine, phenol, thiol, cyano, isocyano, cyanato, nitrato, carboxylato, fluorinated carboxylato, acetylacetonate, fluorinated acetylacetonate, carbonal, amide, imide, thienyl, fluoro, and combinations thereof.

**10.** Optoelectronic component according to any of the preceding claims, wherein the first compound forming at least one coordinate bond with the second compound, to give a chainlike structure and/or a netlike structure.

**11.** Method for producing an optoelectronic component according to claim 1, comprising the method steps of

A) providing a substrate (1)
B) applying a first electrode (2)
C) depositing at least one organic functional layer or a plurality of organic functional layers on the substrate
D) applying a second electrode (9), wherein

the depositing of the organic functional layer taking place by simultaneous vaporization from different sources of a

first compound and of a second compound and of a matrix material.

**12.** Method for producing an optoelectronic component according to the preceding claim, wherein an electron donor-electron acceptor complex being formed by interaction of the first compound with the second compound in the gas phase.

**Revendications**

**1.** Composant optoélectronique comprenant,

- un substrat (1)
- une première électrode (2),
- une deuxième électrode (9),
- au moins une couche fonctionnelle organique disposée entre la première électrode (2) et la deuxième électrode (9), et
- un matériau de la matrice,
- un première composé, et
- comprend un deuxième composé,

le premier composé interagit avec le second composé, et
le premier composé et/ou le second composé interagissant avec le matériau de la matrice, **caractérisé en ce que** une conductivité de la couche fonctionnelle organique est générée par les interactions, et dans laquelle

- au moins une liaison de coordination du premier composé avec le deuxième composé et au moins une liaison de coordination du premier composé avec le matériau de la matrice est formée ou dans laquelle
- au moins une liaison de coordination du premier composé est formée avec le deuxième composé et au moins une liaison de coordination du deuxième composé est formée avec le matériau de la matrice.

**2.** Composant optoélectronique selon la revendication 1,
dans laquelle la couche fonctionnelle organique est choisie dans un groupe comprenant une couche de transport de trous, une couche d'injection de trous et une couche de blocage de trous.

**3.** Composant optoélectronique selon l'une des revendications précédentes,
dans lequel le premier composé est choisi dans un groupe comprenant les unités structurelles ou les formules suivantes:

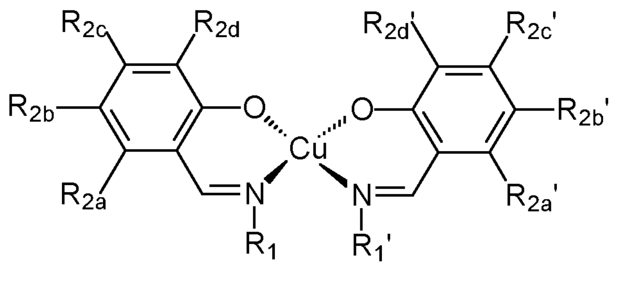

,

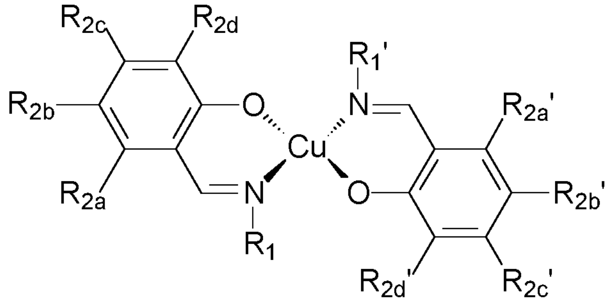

,

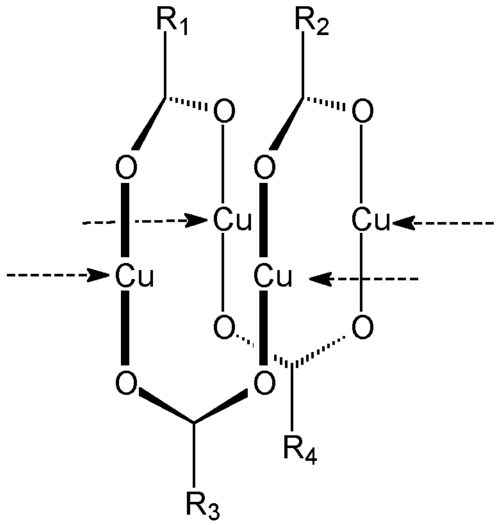

,

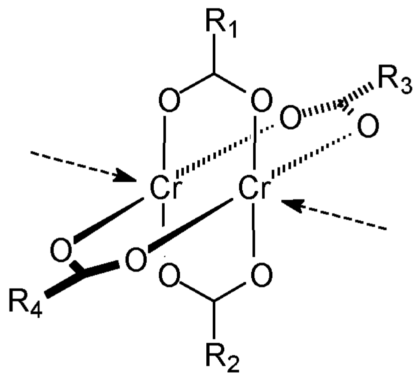

dans laquelle $R_1$, $R_{1'}$, $R_{2x}$ et $R_{2x'}$ sont choisis, indépendamment les uns des autres, dans un groupe comprenant des radicaux alkyle non ramifiés, ramifiés, condensés, cycliques, non substitués et substitués, des aromatiques substitués et non substitués, des hétéroaromatiques substitués et non substitués, dans lequel x est chacun a, b, c ou d,

dans laquelle $R_1$, $R_2$, $R_3$ $R_4$ et/ou $R_4$ sont identiques ou différents et sont chacun choisis dans un groupe comprenant les radicaux hydrocarbonés, les radicaux alkyle, les radicaux cycloalkyle, les radicaux hétérocycloalkyle, les radicaux aryle, les radicaux hétéroaryle et leurs combinaisons, substitués ou non substitués, et dans laquelle le second composé est choisi dans un groupe comprenant le dipyrazino [2,3-f : 2',3'-h]quinoxaline-2,3,6,7,10,11-hexacarbonitrile, 7,7,8,8-tétracyanoquionodiméthane, 2,3,5,6-tétrafluoro-7,7,8,8-tétracyanoquinodiméthane, 2,3-di(N-phtalimido)-5,6-dicyano-1,4-benzoquinone, pyrazino[2,3-f] [1,10]phénanthroline-2,3-dicarbonitrile et ses dérivés fluorés ou non fluorés et tétracyanonaphtoquinodiméthane et ses dérivés fluorés ou non fluorés.

**4.** Composant optoélectronique selon l'une des revendications précédentes,
dans lequel le premier composé est un accepteur d'électrons par rapport au matériau de la matrice et/ou un accepteur d'électrons par rapport au second composé.

**5.** Composant optoélectronique selon l'une des revendications précédentes,
dans lequel le second composé est un accepteur d'électrons par rapport au matériau de la matrice et/ou un donneur d'électrons par rapport au premier composé.

**6.** Composant optoélectronique selon l'une des revendications précédentes,
dans lequel le premier composé comprend un complexe métallique ayant au moins un atome central métallique.

**7.** Composant optoélectronique selon la revendication précédente, dans lequel l'atome central métallique du premier composé est choisi parmi Cu, Cr, Mo et Bi.

**8.** Composant optoélectronique selon l'une des revendications précédentes, dans lequel le second composé comprend un composé aromatique et/ou hétéroaromatique ayant au moins deux groupes fonctionnels capables de former une liaison de coordination et/ou une interaction Π-Π.

**9.** Composant optoélectronique selon la revendication précédente,
dans laquelle les groupes fonctionnels sont choisis dans un groupe comprenant l'amine, la phosphine, le phénol, le thiol, le cyano, l'iso-cyano, le cyanato, le nitrato, le carboxylato, le carboxylato fluoré, l'acétylacétonate, l'acétylacétonate fluoré, le carbonal, l'amide, l'imide, le thiényle, le fluor et les combinaisons comprend d'elle.

**10.** Composant optoélectronique selon l'une des revendications précédentes,
dans laquelle le premier composé forme au moins une liaison de coordination avec le second composé de manière à former une structure en chaîne et/ou une structure en filet.

**11.** Procédé de fabrication d'un composant optoélectronique selon la revendication 1, comprenant les étapes du procédé:

A) fournir un substrat (1)
B) Application d'une première électrode (2)
C) le dépôt d'au moins une couche fonctionnelles organiques ou de plusieurs couches fonctionnelles organiques sur le substrat
D) Application d'une deuxième électrode (9),

dans laquelle le dépôt de la couche fonctionnelle organique est effectué par évaporation simultanée, à partir de différentes sources, d'un premier composé et d'un second composé et d'un matériau de matrice.

**12.** Procédé de fabrication d'un composant optoélectronique selon la revendication précédente, dans lequel un complexe donneur d'électrons-accepteur d'électron est formé par l'interaction du premier composé avec le second composé en phase gazeuse.

Fig. 1

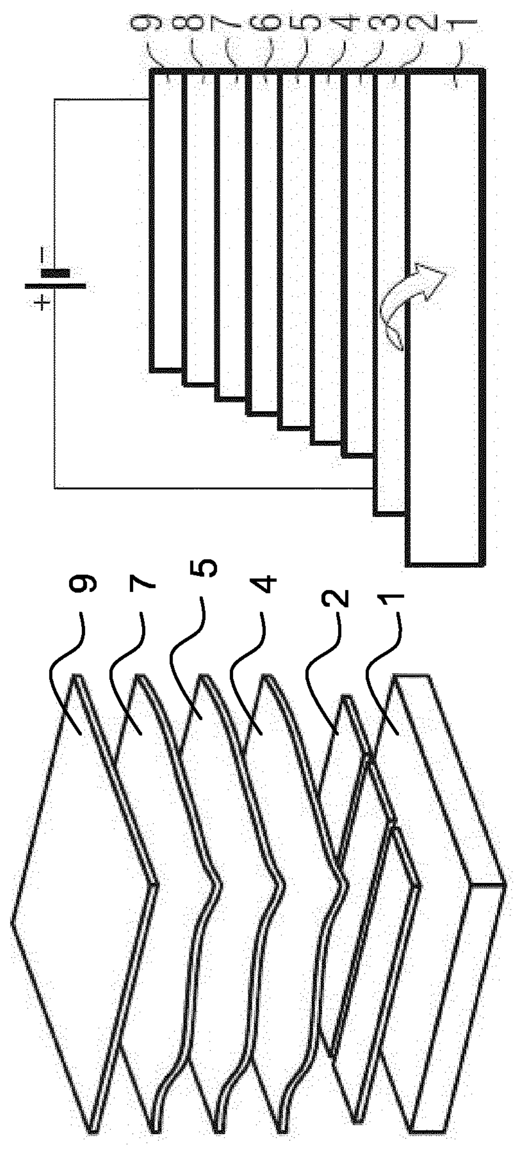

Fig. 2

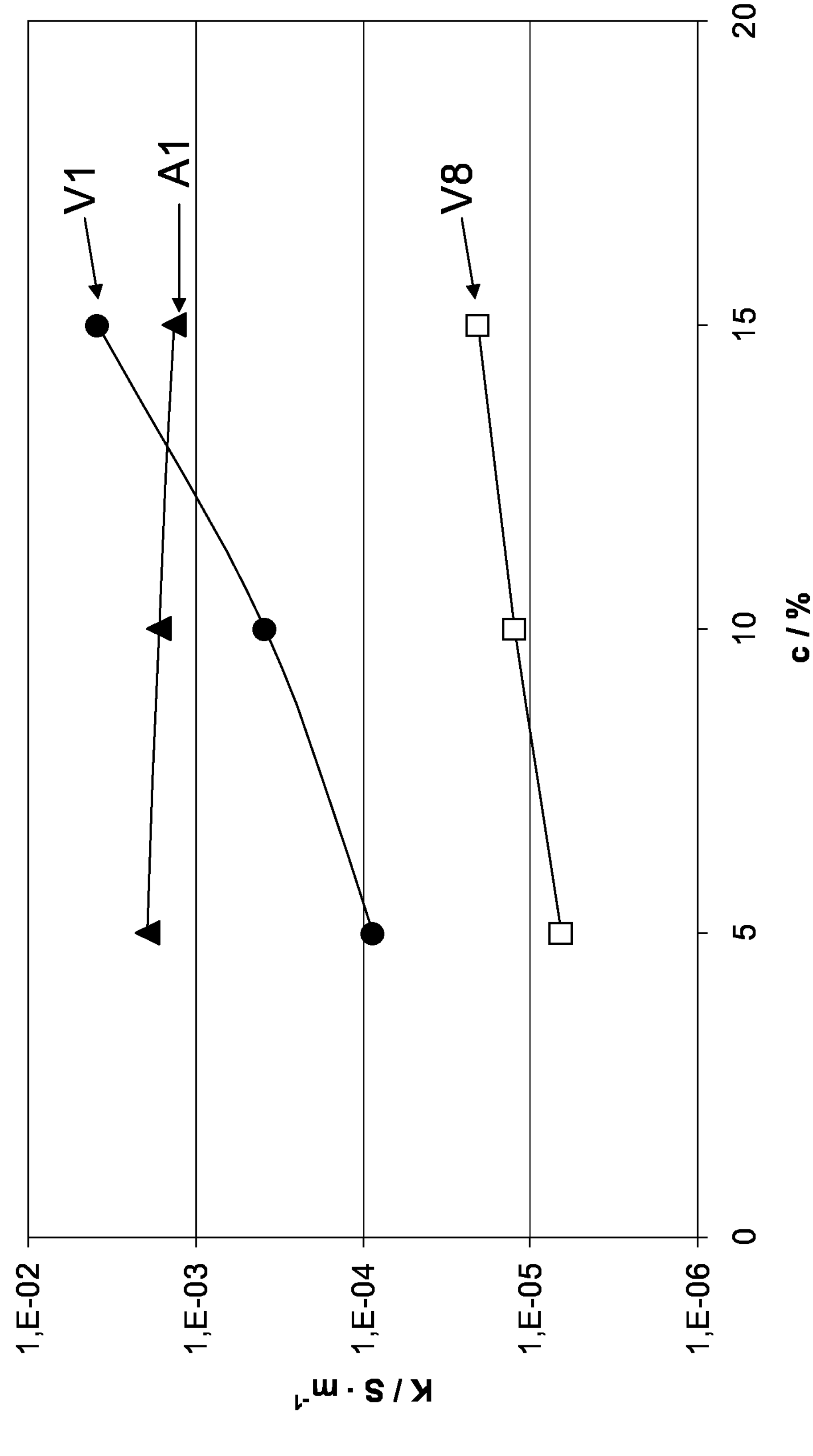

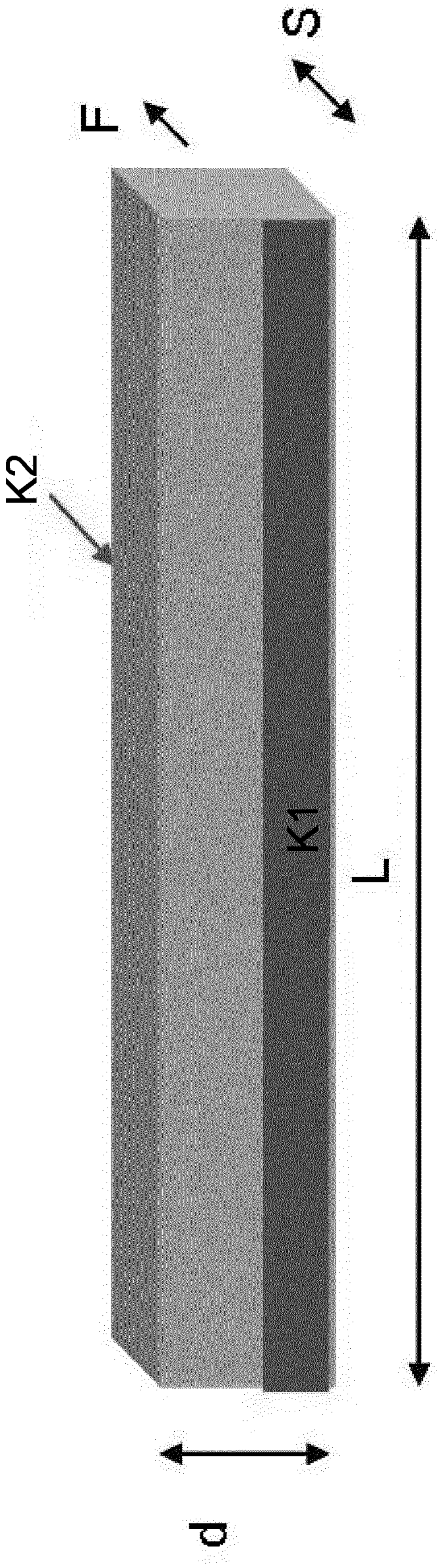


Fig. 2a

Fig. 3

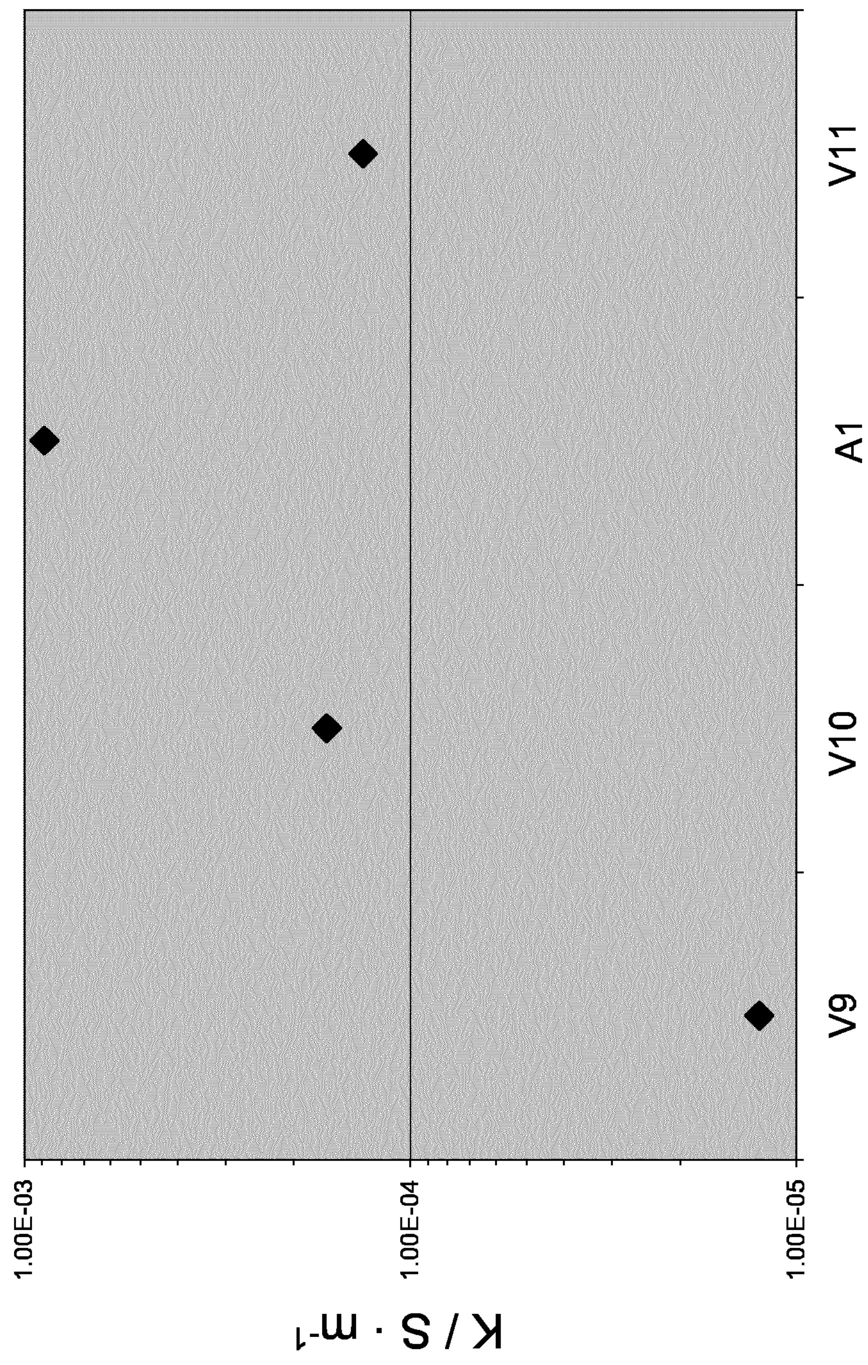

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2011033023 A1
- US 20110089408 A1
- DE 102010013495 A1
- WO 2011120709 A1
- DE 102007028237 A1
- DE 102007028238 A1


### In der Beschreibung aufgeführte Nicht-Patentliteratur


- **SEVRYUGINA et al.** *Inorg. Chem.,* 2007, vol. 46, 7870-7879